# EUROPÄISCHE PATENTSCHRIFT

(11) **EP 3 130 206 B1**
(45) Veröffentlichungstag und Bekanntmachung des Hinweises auf die Patenterteilung: **30.03.2022**
(21) Anmeldenummer: 15727537.1
(22) Anmeldetag: 10.04.2015
(51) Int. Cl.: H05K 3/38, C23C 14/02, C23C 16/02, C23C 14/20, C23C 16/06

(54) **VERFAHREN ZUR HERSTELLUNG EINES HAFTFESTEN VERBUNDES**
METHOD FOR PRODUCING A FIRMLY ADHERING ASSEMBLY
PROCÉDÉ POUR LA FABRICATION D'UN COMPOSITE ADHÉSIF

(30) Priorität: 11.04.2014 DE 102014005441
(43) Veröffentlichungstag der Anmeldung: 15.02.2017
(73) Patentinhaber: Danziger, Elena, 06485 Quedlinburg (DE)
(72) Erfinder: DANZIGER, Manfred, 06485 Quedlinburg (DE)
(74) Vertreter: Fischer, Volker
(86) Internationale Anmeldenummer: PCT/DE2015/000178
(87) Internationale Veröffentlichungsnummer: WO 2015/154745

(56) Entgegenhaltungen:
- US-A1- 2007 286 964
- US-A1- 2011 064 887
- US-B1- 6 342 307

## Beschreibung

Die Erfindung betrifft ein Verfahren zur Herstellung eines haftfesten Verbundes eines Substratmaterials, bestehend aus einem thermoplastischen Kunststoff mit einer unbehandelten oder einer zur Erzielung einer Vorstrukturierung behandelten Oberfläche, mit einem anderen Material, zum Beispiel aus der Gruppe der Metalle, der halbleitenden Materialien oder der keramischen Materialien, insbesondere der Metalloxide. Ein Vorteil der Erfindung betrifft einen entsprechenden haftfesten Verbund eines thermoplastischen Kunststoffs/Polymers als Substratmaterial mit dem anderen Material, der durch das genannte Verfahren erhältlich ist.

Ein haftfester Verbund zweier unterschiedlicher Materialien, wie beispielsweise eines Substratmaterials mit einem anderen Material, ist eine unabdingbare Voraussetzung für eine Vielzahl technischer Anwendungen entsprechender Verbundmaterialien. Insbesondere für thermoplastische Polymermaterialien bildet zum Beispiel die haftfeste Metallisierung ihrer Oberflächen die Grundlage zahlreicher, oftmals technologisch hochwertiger Anwendungen.

Mit einigen bekannten Verfahren lassen sich bereits solide haftfeste Verbunde zwischen einem Substratmaterial und einer aufzubringenden Schicht, zum Beispiel einer Kupferschicht, erzeugen.

Aus der US 6,342,307 B1 ist ein Verfahren zur Erzeugung eines haftfesten Verbundes einer Metallschicht mit einer Polymeroberfläche bekannt. Dieses Verfahren umfasst die folgenden wesentlichen Verfahrensschritte:
I. Auf die Oberfläche des Polymers wird derart Metall aufgetragen, dass sich keine geschlossene Metallschicht ausbildet, sondern Ablagerungen in Form von Metallpartikeln mit Abmaßen im Bereich von 5 bis 20 nm entstehen. Die Prozessbedingungen werden dabei so gewählt, dass keine Beeinflussung der Polymeroberfläche stattfindet. Die Temperatur liegt unterhalb der Glastemperatur. Die Polymeroberfläche wird dann bis oberhalb der Glastemperatur erwärmt und die Partikel werden so in die Oberflächenschicht des Polymers eingearbeitet, dass sie mindestens bis zur Hälfte, aber nicht vollständig in das Polymer eingebettet sind. Nach dem Abkühlen sind die noch aus der Polymeroberfläche herausragenden Partikel fest in dieser Oberfläche verankert.
II. Abschließend wird auf die so vorbereitete Oberfläche erneut Metall abgeschieden, wobei der Prozess so geführt wird, dass sich eine geschlossene Metallschicht herausbildet. Dabei verbindet sich das neu hinzukommende Metall mit den aus der Oberfläche des Polymers herausragenden Metallpartikeln. Es entsteht eine durch die in das Polymer eingebetteten Partikelteile fest auf der Polymeroberfläche verankerte Metallschicht.

Bei allen Verfahrensschritten wird darauf geachtet, dass das Metall ohne chemische Veränderung abgeschieden wird. Insbesondere wird Wert darauf gelegt, dass das Metall nicht oxidiert. Nach dem in der US 6,342,307 B1 beschriebenen Verfahren wird zur Unterstützung der Adhäsionskräfte eine formschlüssige Verbindung zwischen Metall und Polymer erzeugt.

In der US 4,064,030 A ist ein Verfahren beschrieben, mit dem sich eine Oberflächenvergrößerung eines fluorierten Olefin-Polymers realisieren lässt. Die Oberfläche von Fluorpolymerolefinen wird mittels eines sogenannten Sputterätzprozesses bei einem Druck von 0,0005 bis 0,5 Torr bearbeitet. Dieser lonenätzprozess wird mit einer Hochfrequenz-Dioden-Sputteranordnung zur Beschleunigung von Ionen, die auf die Polymeroberfläche auftreffen, durchgeführt. Dieser Prozess wird auch RF-Dioden-Sputtern genannt.

In der Druckschrift Chang et al. (Appl. Phys. Lett. 51(2), 13 July 1987) wird eine Methode zur Oberflächenstrukturierung von Polytetrafluorethylen-Materialien (PTFE-Materialien) mit einer nachfolgenden Kupfer-Metallisierung der strukturierten PTFE-Oberfläche mittels Kathodenzerstäubung, speziell mittels Magnetronsputtering, beschrieben, mit dem Ziel, den Verbund zwischen dem PTFE-Material und der Kupferschicht zu verbessern. Es wird beschrieben, dass durch die Oberflächenbearbeitung durch die Anwendung einer Kauffmann-Ionenquelle im Vakuum auf der Oberfläche sogenannte "Filaments", das heißt Fädchen, herausgearbeitet werden, die dann in einem Kathodenzerstäubungsprozess, dem Magnetronsputtering, mit Kupfer beschichtet werden, wobei sich die aufgetragene Kupferschicht der Oberflächenmorphologie anpasst.

In der DE 100 58 822 A1 ist in einem Beispiel die Erzeugung einer stark zerklüfteten, hochgebirgsartigen Oberfläche und eines ausgeprägten Tiefenreliefs auf einer Polyesterfolie auf der Grundlage der lonenspurtechnologie, also im speziellen Fall durch den Beschuss von Ionen, die in einem Einfallswinkelbereich der in den Festkörper eindringenden Ionen von -30° bis +30° relativ zur Oberflächennormalen eindringen, und einer Eintrittsenergie von 0,11 MeV/amu (Megaelektronenvolt/ Atommasseneinheit), die nach dem Bestrahlungsprozess einer 6- bis 8-minütigen Ätzung mit 5-normaler Natriumhydroxidlösung ausgesetzt wird, beschrieben. Im Anschluss daran wird die so formierte Oberfläche der Folie mit ihrer ausgeprägten Morphologie bei einem Arbeitsdruck von ≤ 5 × 10⁻² mbar mit Aluminium bedampft.

Die US 2011/064887 A1 offenbart ein Verfahren zur Herstellung von Werkstücken, deren Oberfläche mittels stromloser Plattierung plattiert werden sollen. Das Verfahren umfasst einen Ozonverarbeitungsschritt und einen Schritt, bei dem die Oberfläche entfernt wird. In dem Ozonverarbeitungsschritt wird ein Werkstückkörper, der ein Harz enthält und eine Oberfläche aufweist, mittels einer Ozonbehandlung verarbeitet, indem der Werkstückkörper mit einer Lösung, die Ozon enthält, in Berührung gebracht wird. Somit wird eine modifizierte Schicht auf der Oberfläche des Werkstückkörpers ausgebildet. Dann wird in dem Schichtentfernungsschritt eine oberflächliche Schicht aus der resultierenden modifizierten Schicht entfernt, indem Energie auf die modifizierte Schicht aufgebracht wird.

Die US 2007/286964 A1 offenbart ein Verfahren zum Verbessern der elektrischen Verbindungseigenschaften der Oberfläche eines Produkts aus einem Polymermatrix-Verbundwerkstoff, der einen Füllstoff umfasst. Das Verfahren umfasst die folgenden Schritte:
- Erwärmen der Oberfläche des Produkts auf eine erste Behandlungstemperatur oberhalb der Umgebungstemperatur;
- eine erste Plasmabehandlung der Oberfläche, wodurch ein Entfernen von Oberflächenpolymer und ein Freilegen von Füllstoff durch Sauerstoffradikale bewirkt wird;
- Abkühlen der plasmabehandelten Oberfläche des Produkts auf eine zweite Behandlungstemperatur unterhalb der ersten Behandlungstemperatur;
- eine zweite Plasmabehandlung der Oberfläche, die durch die erste Plasmabehandlung erzeugt wurde, wodurch eine Aktivierung der Oberfläche durch Sauerstoffradikale bewirkt wird;
- Abscheiden einer Metallisierung auf der Oberfläche, die durch die zweite Plasmabehandlung erzeugt wurde.

Die DE 10 2004 011 567 A1 betrifft einen haftfesten Verbund eines Substratmaterials, dessen Oberfläche und dessen oberflächennaher Festkörperbereich Polymerverbindungen mit geringer aktiver Oberflächenenergie aufweisen, mit einem anderen Material und ein Verfahren zur Herstellung eines entsprechenden haftfesten Verbundes. Hierbei wird der haftfeste Verbund durch einen nanostrukturierten, Nanokomposite enthaltenden Übergangsbereich zwischen dem Substratmaterial und dem anderen Material gebildet, innerhalb dessen das Substratmaterial nanostrukturiert in das andere Material übergeht. Die Nanokomposite setzen sich aus Substratmaterial und dem anderen Material zusammen, wobei die Materialanteile der Nanokomposite vom Substratmaterial in Richtung des anderen Materials, ausgehend von überwiegend Substratmaterial zu überwiegend dem anderen Material, übergehen. Erzeugt wird ein haftfester Verbund, indem eine vorher, also zum Beispiel in einem vorangehenden Oberflächenbearbeitungsprozess, erzeugte nanozerklüftete Oberfläche des Substratmaterials physikalisch und/oder chemisch angeregt wird und innerhalb des angeregten Zustandes ein partikelweiser Auftrag des anderen Materials erfolgt, bis ein vollständiger Überzug der Polymerverbindungen mit einer eine geringe aktive Oberflächenenergie aufweisenden Oberfläche des Substratmaterials mit dem anderen Material erreicht ist. In der DE 10 2004 011 567 A1 wird weiterhin ausgeführt, dass es zur Realisierung eines haftfesten Verbundes notwendig ist, dass die Oberfläche und der oberflächennahe Bereich nanozerklüftet sein müssen. Diese Nanozerklüftung ist mit einer fraktalen Strukturierung vergleichbar und weist geometrische Strukturelemente im Nanometerbereich auf, die in dieser Schrift als Nanoklippen bezeichnet werden. Fraktale sind selbstähnliche Gebilde, das heißt, ein Teil eines Fraktals ergibt, geeignet vergrößert, wieder genau das Ganze. Fraktale Strukturen sind hochkomplex, wenn die sie beschreibenden Algorithmen auch sehr simpel sein können. Dies äußert sich darin, dass sie mehr Details preisgeben, wenn sie vergrößert werden. Die Selbstähnlichkeit eines Fraktals fundiert auf der Tatsache, dass es durch wiederholt angewendete einfache Algorithmen, zum Beispiel festgeschriebene, sich wiederholende Herstellungsschritte, reproduziert bzw. aufgebaut werden kann. Zur Ausbildung einer entsprechenden Nanozerklüftung der Oberfläche und des oberflächennahen Festkörperbereiches der Polymerverbindungen mit einem eine geringe aktive Oberflächenenergie aufweisenden Substratmaterial sind zum Beispiel die lonenspurtechnologie und/oder nasschemische Verfahren bekannt. Das in der DE 10 2004 011 567 A1 vorgestellte Verfahren führt zu immensen Haftfestigkeitswerten zwischen oberflächenstrukturiertem bzw. nanostrukturiertem Substratmaterial und der aufzubringenden Schicht, zum Beispiel einer Kupferschicht.

Dennoch sind alle erwähnten Verfahren mit, wenn auch geringen, aber feststellbaren Nachteilen verbunden, die sich insbesondere bei der Weiterverarbeitung des erzeugten Komposits teilweise sogar signifikant bemerkbar machen können. Insbesondere bei Fluorpolymeren ist festzustellen, dass sich die Stärke des Haftverbundes im Falle des direkten Kontaktes des Materials mit wässriger Lösung verringert. In extremen Fällen kann sich die Haftfestigkeit um 50 % bis 70 % reduzieren. Bei nachfolgender Trocknung, das heißt nachdem das Material aus der wässrigen Lösung herausgenommen und im Anschluss daran getrocknet wird, baut sich der Haftfestigkeitswert wiederum auf und erreicht nach erfolgter Trocknung wieder den ursprünglich gemessenen außerordentlich großen Haftwert. Dieser Effekt tritt jedoch nur auf, wenn ein direkter Kontakt des Materials mit wässrigen Lösungen vorliegt. Bei Veränderungen der relativen Luftfeuchtigkeit zum Beispiel macht sich dieser Effekt kaum oder gar nicht bemerkbar. Allerdings kann bei der Verarbeitung vollständig verkupferter Polymerfolien, die als Leiterplattenbasismaterialien zum Einsatz kommen, zu Leiterplatten der Fall der direkten Kontaktierung mit wässrigen Lösungen mehrmals durch nacheinander ablaufende Prozessschritte auftreten. Immer dann, wenn dieser Kontakt vorhanden ist, ist auch eine Schwächung des Haftverbundes festzustellen, was besondere Verarbeitungsbedingungen, die unbedingt und strikt zu beachten sind, erfordert, weil es sonst dazu führen kann, dass sich der Verbund während der Prozessierung löst. Dadurch wäre das Material unbrauchbar und nicht weiter verarbeitbar. Dieser Effekt hat eine physikalische/chemische Ursache. Um diesen Effekt genauer veranschaulichen zu können, sind noch einige zusätzliche Vorbetrachtungen erforderlich, die später noch anhand von Figuren erläutert werden.

Thermoplastische Kunststoffe, auch Thermoplaste oder thermoplastische Polymere genannt, gehören zu den Kunststoffen. Die verschiedenen Eigenschaften der Kunststoffe basieren auf ihrem unterschiedlichen molekularen Aufbau. Kunststoffe bestehen aus großen Molekülketten bzw. Makromolekülen, welche unterschiedlich angeordnet und vernetzt sein können. Fast alle Kunststoffe lassen sich sehr leicht formen, da sie bei der Herstellung oder Verarbeitung den plastischen Zustand durchlaufen. Aufgrund ihrer unterschiedlichen Eigenschaften und Verhaltensweisen gegenüber Erwärmung und Elastizität werden sie in drei Gruppen eingeteilt: in Thermoplaste, in Duroplaste und in Elastomere. Die unterschiedlichen Eigenschaften der verschiedenen Gruppen werden bestimmt von den zwischenmolekularen Kräften, das heißt von ihrer chemischen Zusammensetzung, ihren polaren Bindungen, der Größe der Substituenten und der Länge sowie der Form der Makromoleküle, das heißt, ob sie linear oder verzweigt sind, sowie der Struktur. Chemisch betrachtet fehlt den Thermoplasten - im Gegensatz zu den Duroplasten - die Quervernetzung, die einzelnen Molekülketten sind also nicht durch chemische Bindungen, sondern nur durch zwischenmolekulare Kräfte miteinander verbunden.

Thermoplastische Kunststoffe können beliebig oft durch Temperaturerhöhung erweicht und nach dem Abkühlen wieder verfestigt werden. Sie bestehen aus linearen oder verzweigten Kettenmolekülen, die nicht vernetzt sind. Je nach Molekülaufbau und -struktur lassen sich die Thermoplaste in ungeordnete und teilkristalline aufteilen. Die langen, wenig verzweigten Molekülketten von Thermoplasten, die nicht vernetzt sind und sich gegeneinander verschieben können, können sowohl geordnet als auch ungeordnet vorliegen und somit Kristalle oder amorphe Festkörper bilden. Bei den meisten Kunststoffen liegen die Ketten teilweise gefaltet und teilweise ohne besondere Struktur vor, und dementsprechend ordnet sich beim Feststoff nur ein Teil der Molekülketten und bildet Kristallstrukturen aus, der Rest liegt amorph vor.

Amorphe Thermoplaste, also thermoplastische Festkörper, die keine erkennbare, sich wiederholende Ordnung der einzelnen Teilchen, das heißt Moleküle, Atome und Ionen, aufweisen, haben keinen Schmelzpunkt. Sie gehen in einem bestimmten Temperaturbereich von der harten in eine flexible Phase über. Gekennzeichnet ist dieser Bereich dadurch, dass die Molekülketten beweglich werden, ohne dass sich der Kunststoff direkt verflüssigt. Dies geschieht erst bei weiter steigender Temperatur. Die Glasübergangs- oder Erweichungstemperatur (T_{G}) ist die Temperatur, bei der ein Glas oder ein amorpher Kunststoff die größte Änderung der Verformungsfestigkeit aufweist. Dieser sogenannte Glasübergang trennt den unterhalb liegenden spröden energieelastischen Bereich, den sogenannten Glasbereich, vom oberhalb liegenden weichen entropieelastischen Bereich, dem sogenannten gummielastischen Bereich. Der Übergang in den Fließbereich des amorphen Kunststoffs ist fließend. Die Glasübergangstemperatur charakterisiert somit das Polymerverhalten, das heißt die Beweglichkeit der Makromoleküle gegeneinander. Sie kann zum Beispiel über die Messung des Schubmoduls bestimmt werden.

Teilkristalline Thermoplaste haben ebenfalls eine Glasübergangstemperatur, diese betrifft jedoch nur die amorphen Bereiche. Meist liegt die Glasübergangstemperatur unterhalb des Schmelzpunktes, so dass zwischen diesen beiden Temperaturen eine harte und eine flexible Phase gleichzeitig existieren. Kennzeichnend für diese Werkstoffe ist ein duktiles mechanisches Verhalten. Teilkristalline Kunststoffe besitzen sowohl eine Glasübergangstemperatur, unterhalb derer die amorphe Phase "einfriert", einhergehend mit einer mehr oder weniger starken Versprödung, als auch eine Schmelztemperatur, bei der sich die kristalline Phase auflöst. Die Schmelztemperatur trennt den entropieelastischen Bereich deutlich vom Fließbereich ab. Der Übergang vom Glaszustand in den flüssigen Zustand ist somit nicht dasselbe wie Schmelzen. Beim Glasübergang werden die bei tieferen Temperaturen eingefrorenen Polymerketten beweglich. Das Material beginnt unter mechanischer Belastung zu fließen. Bei weiterer Erhöhung der Temperatur können solche Polymere leicht aus der Schmelze verarbeitet werden. Bei teilkristallinen Thermoplasten lässt sich der Glasübergang auch bestimmen, die Verformbarkeit ist jedoch etwas beschränkter. Erst wenn der Kristallitschmelzpunkt erreicht ist, erfolgt auch hier eine vollständige Verformbarkeit. Schmelzen bei den Thermoplasten die Kristallite nun oberhalb der Fließtemperatur T_{f} "plötzlich" auf, also bei der Temperatur, bei der eine ausreichend niedrige Viskosität bzw. Fließfähigkeit erreicht ist, um eine sogenannte Urformung bzw. Formgebung des Festkörpers durchzuführen, so können kaum noch mechanische Kräfte aufgenommen werden und der Werkstoff fließt. Bei teilkristallinen Thermoplasten heißt die Fließtemperatur Kristallitschmelztemperatur Tₘ.

Der Erfindung liegt die Aufgabe zugrunde, einen haftfesten Verbund zwischen einem thermoplastischen Substratmaterial mit einem anderen Material in einem Verfahren zur Herstellung eines entsprechenden haftfesten Verbundes bereitzustellen, wobei die genannten Nachteile des Standes der Technik vermieden werden sollen. Zur Lösung des vorhandenen und bereits beschriebenen Problems können überraschenderweise spezielle Eigenschaften des thermoplastischen Verhaltens der Polymermaterialien ausgenutzt werden.

Erfindungsgemäß wird dieses Problem durch ein Verfahren zur Herstellung eines haftfesten Verbundes eines Substratmaterials, bestehend aus einem thermoplastischen Kunststoff mit einer unbehandelten oder einer zur Erzielung einer Vorstrukturierung behandelten Oberfläche, mit einem anderen Material, das die Merkmale des Patentanspruchs 1 oder 2 aufweist, gelöst. Die Patentansprüche 3 bis 14 beschreiben vorteilhafte Ausgestaltungen des Verfahrens. Dabei wird eine erste aufgebrachte Schicht des anderen Materials mit einer nanoskaligen Schichtdicke durch thermische Behandlung in das thermoplastische Material vollständig bzw. nahezu vollständig eingebettet, wobei unter nahezu zu verstehen ist, dass höchstens einige Bestandteile der strukturellen Komponenten, aus denen die aufgebrachte Schicht besteht, aus der Einbettung herausragen können, d.h. unter nahezu ist eine 85- bis 99%ige Einbettung des Volumens der eingebetteten Komponenten zu verstehen. Das Material sollte dabei aber so eingebettet sein, dass die Oberfläche des eingebetteten Materials an der Gesamtoberfläche aber nicht mehr als 35 % beträgt. Im Anschluss daran wird die Oberfläche des anderen Materials durch Beschuss mit energetischen Schwerionen so freigelegt, dass der Anteil an der Gesamtoberfläche durch das eingebettete Material mindestens 10 %, in der Regel jedoch mehr als 50 %, beträgt, und aktiviert, und wiederum im Anschluss daran wird die gesamte Oberfläche mit dem anderen Material beschichtet, bis sich mindestens eine geschlossene Schicht des anderen Materials ausbildet. Gemäß der Internationalen Organisation für Normung (ISO) wird unter nanoskalig der Größenbereich zwischen 1 und 100 Nanometern verstanden.

In einer Ausführungsform des erfindungsgemäßen Verfahrens weist das Substratmaterial eine unbehandelte oder schwach vorstrukturierte Oberfläche auf, die mit dem aufzubringenden Material beschichtet wird. Jede Oberfläche weist eine natürliche Rauheit auf, wobei unter Rauheit die Unebenheit der Oberflächenhöhe zu verstehen ist. Unter schwach vorstrukturiert soll verstanden werden, dass durch verschiedene mögliche spezielle Oberflächenbearbeitungsverfahren die vorhandene Oberflächenstruktur so verstärkt wird, dass die mittlere Rauheit Rₐ, die den mittleren Abstand eines Messpunktes auf der Oberfläche zur Mittellinie angibt, verdoppelt oder verdreifacht wird. Das Verhältnis zwischen Höhe der höchsten und den niedrigsten Profilanteilen beträgt maximal 2.

Vorzugsweise wird die in dieser Ausgestaltung der Erfindung vorgesehene schwache Vorstrukturierung der Oberfläche durch Plasmaätzen, plasma-unterstütztes Ätzen oder durch Bearbeitung mit energetischen Schwerionen erzielt. Stand der Technik ist hierbei:
Plasmaätzen ist ein materialabtragendes, plasmaunterstütztes, gaschemisches Trockenätz-Verfahren. Beim Plasmaätzen erfolgt ein Materialabtrag durch eine chemische Reaktion. Deshalb ist es im Allgemeinen eigentlich isotrop und aufgrund des chemischen Charakters auch sehr materialselektiv. Durch ionisierte Moleküle eines Prozessgases entstehen Ionen, die in einem elektrischen Feld beschleunigt werden und auf die Oberfläche des Substrats treffen. Beim Plasmaätzen gibt es zwei unterschiedliche Varianten. Im ersten Fall reagieren die auftreffenden Ionen mit den Substratteilchen zu gasförmigen Verbindungen. In der anderen Variante schlagen die auftreffenden Ionen aufgrund des Impulsübertrages beim Aufprall Teilchen aus der Substratoberfläche heraus. Mit einer Ätzbehandlung kann bei teilkristallinen Thermoplasten die amorphe Phase stärker abgebaut und entfernt werden. Die kristallinen Anteile bleiben hauptsächlich zurück und bilden ein Oberflächenrelief.

Plasmaunterstütztes Ätzen, auch physikalisch-chemisches Ätzen genannt, bezeichnet eine Gruppe von subtraktiven, d.h. abtragenden Verfahren. Der Materialabtrag erfolgt mithilfe plasmaaktivierter Gase und beschleunigter Ionen, zum Beispiel Argonionen. Es werden zwei Ätzmechanismen in einem Prozess genutzt, zum einen der lonenbeschuss des Substrates und zum anderen eine chemische Reaktion an dessen Oberfläche. Der Beschuss mit dem ionisierten Reaktionsgas oder anderen Ionen schwächt oder zerstört die chemischen Bindungen der Atome an der Oberfläche, so dass das reaktive Gas leichter reagieren kann und so den chemischen Effekt in den betroffenen Gebieten verstärkt. Dies geschieht, indem das lonenbombardement die Energie zuführt, die für die Aktivierung der chemischen Reaktion erforderlich ist.

lonenstrahlätzen, also die Bearbeitung mit energetischen Schwerionen, funktioniert ähnlich wie das lonenätzen, aber die Ionen werden in einem Strahl gebündelt. Daher ist die Wirkung richtungsabhängig, d.h. anisotrop, und nicht selektiv.

Mit den genannten Verfahren lassen sich Bereiche der Polymeroberfläche stärker abbauen als benachbarte Bereiche, sodass sich ein ausgeprägteres Oberflächenprofil bzw. Oberflächenrelief mit einer größeren mittleren Rauheit Rₐ herausbildet. Rₐ wird in der Regel im Vergleich zum ursprünglichen Oberflächenprofil verdoppelt oder verdreifacht. Bei sehr glatten Oberflächen, d.h. bei denen Rₐ kleiner als 0,2 µm ist, kann eine Vergrößerung um den Faktor 5 bis 10 erzielt werden.

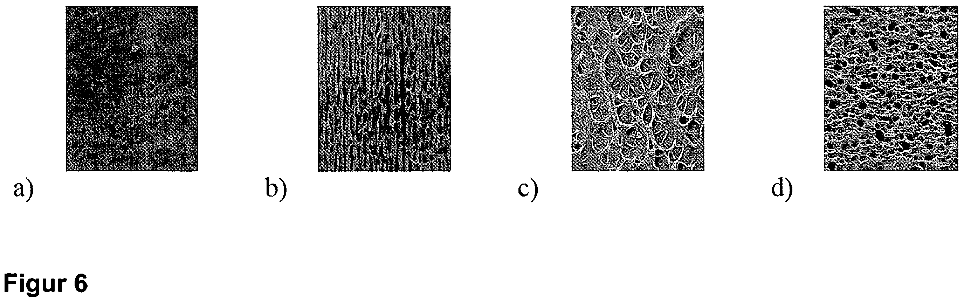

In den später detailliert beschriebenen **Figuren 6b** bis **d** sind Rasterelektronenmikroskopaufnahmen verschiedener schwach vorstrukturierter Oberflächen abgebildet. Unter einer schwachen oder geringen Vorstrukturierung ist demnach zu verstehen, dass die Form des ursprünglichen Oberflächenreliefs nach der Oberflächenbearbeitung prinzipiell erhalten bleibt. Mit den zum Stand der Technik zu zählenden Oberflächenbearbeitungsmethoden wird lediglich eine stärkere Ausprägung des ursprünglichen Profils entsprechend einer Ähnlichkeitsbeziehung erzielt. Mit der Anwendung dieser Methoden werden noch keine Strukturmuster erzeugt, die als Strukturelemente angesehen werden können.

Mit anderen Worten, die Herstellung eines haftfesten Verbundes eines thermoplastischen Polymers als Substratmaterial bzw. Trägermaterial mit dem aufzubringenden anderen Material erfolgt, indem auf eine nicht oder, wegen der damit verbundenen Erhöhung der Oberflächenenergie, nur gering vorstrukturierte Oberfläche des thermoplastischen Polymermaterials, deren Abmaße und Strukturierungsgrad bei weitem nicht der Oberflächentopographie entsprechen, die mittels spezieller Oberflächenbearbeitungsmethoden aus dem oberflächennahen Festkörperbereich herausgearbeitet wird, mit speziellen Beschichtungsverfahren nur wenige Monolagen des aufzubringenden Materials deponiert werden. Die Struktur des aufgebrachten Materials entspricht dabei einer Clusterstruktur, das heißt einer porösen, perkolierenden oder fraktalen Strukturform des Materials mit einer nanoskaligen Schichtdickenausdehnung, die die Oberfläche des thermoplastischen Polymers partiell bedeckt. Dabei entsprechen diese aufgebrachten Lagen inselförmig gewachsenen Körnern, die als Cluster bezeichnet werden, die bevorzugt in Richtung des während des Beschichtungsprozesses auftreffenden Partikelstroms gewachsen sind. Diese Schichten besitzen eine hohe Porosität, geringe Dichte und große Rauigkeit.

Der Oberflächenbereich des thermoplastischen Polymers wird in dieser Ausführungsform mit der in Form einer Clusterstruktur aufgebrachten Schicht des anderen Materials, die vorzugsweise eine Dicke von 5 bis 30 nm aufweist, in einem vorgegebenen Zeitintervall, d.h. impulsartig mit einer Impulsdauer im Bereich von 1 ms bis 100 s, durch Wärmezufuhr beeinflusst, wobei die Temperatur der Wärmequelle bis zu 500 K oberhalb der Schmelztemperatur des Polymermaterials liegt, so dass der Betrag der einzubringenden Wärmemenge so dimensioniert ist, dass vornehmlich in den Bereichen des Substratmaterials, die sich in unmittelbarem Kontakt zu den aufgebrachten Clustern befinden, die Formänderungsfähigkeit des thermoplastischen Polymers zunimmt, bis es beginnt, zu fließen und die Schichtstrukturen des aufgebrachten Materials in das Polymermaterial vollständig bzw. nahezu vollständig einsinken. Die Wirkung des Wärmeeintrages kann deshalb als eine Schock-Erwärmung des oberflächennahen Festkörperbereiches betrachtet werden.

In einer anderen Variante der oben genannten Ausführungsform wird der Oberflächenbereich des thermoplastischen Polymers mit der in Form einer Clusterstruktur aufgebrachten Schicht des anderen Materials, die vorzugsweise eine Dicke von 5 bis 30 nm aufweist, in einem vorgegebenen Zeitintervall, d.h. impulsartig mit einer Impulsdauer im Bereich von 1 ms bis 100 s, durch Wärmezufuhr beeinflusst, wobei die Temperatur der Wärmequelle bis zu 500 K oberhalb der Schmelztemperatur des Polymermaterials liegt, und auf diese Schicht ein Druck, also eine Kraft pro Fläche, der im Bereich zwischen 10 % und 150 % der Zugfestigkeit des Polymermaterials liegt, ausgeübt. Dabei wird der Betrag der einzubringenden Wärmemenge und der Druck dergestalt dimensioniert, dass vornehmlich in den Bereichen des Substratmaterials, die sich in unmittelbarem Kontakt zu den aufgebrachten Clustern befinden, die Formänderungsfähigkeit des thermoplastischen Polymers zunimmt, bis es beginnt zu fließen und die Schichtstrukturen des aufgebrachten Materials in das Polymermaterial vollständig bzw. nahezu vollständig einsinken.

Die Herstellung des haftfesten Verbundes kann alternativ mit einem thermoplastischen Polymer als Substratmaterial bzw. Trägermaterial erfolgen, dessen Oberfläche über eine mittels spezieller Oberflächenbearbeitungsmethoden aus dem oberflächennahen Festkörperbereich herausgearbeitete Struktur verfügt, wie z.B. mit der lonenspurtechnologie und/oder mit nasschemischen Oberflächenbearbeitungsverfahren oder mit der Oberflächenbearbeitung von Fluorpolymeren mit energetischen Ionen.

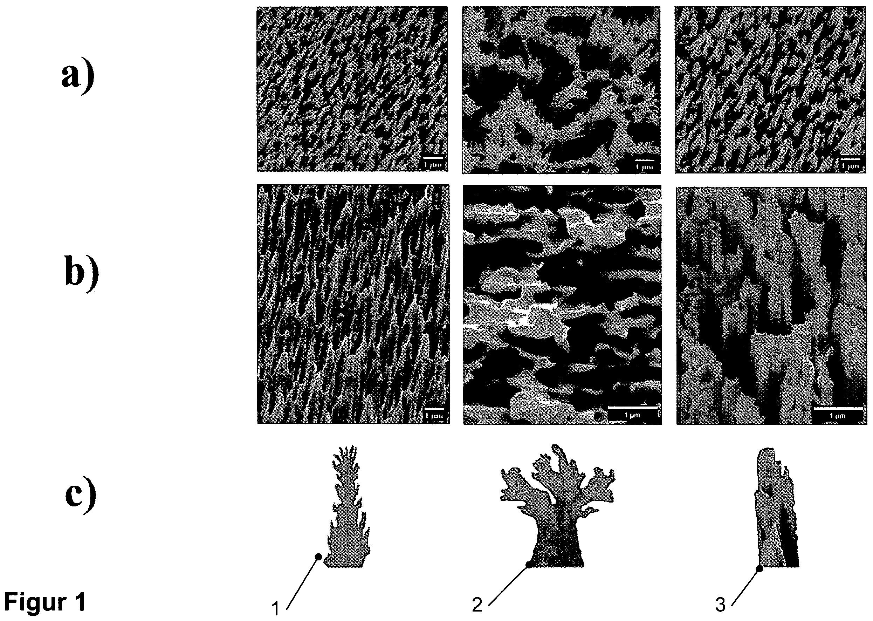

In dieser Ausführungsform des erfindungsgemäßen Verfahrens weist das Substratmaterial somit eine stark vorstrukturierte Oberfläche auf. Bei stark vorstrukturierten Oberflächen beträgt die mittlere Rauheit Rₐ, die den mittleren Abstand eines Messpunktes auf der Oberfläche zur Mittellinie angibt, einen Wert größer als 0,3 µm. Das Verhältnis zwischen der Höhe der einzelnen Strukturelemente und einer ihrer radialen Ausdehnungen, d.h. Ausdehnungen in x- oder y-Raumrichtung, beträgt mindestens 3. In der später noch detailliert erläuterten **Figur 1a** sind Rasterelektronenmikroskopaufnahmen von stark vorstrukturierten Fluorpolymermaterialien, die durch die Oberflächenbearbeitung mit energetischen Schwerionen erzeugt worden sind, abgebildet. In der ebenfalls später noch detailliert erläuterten **Figur 1b** sind Rasterelektronenmikroskopaufnahmen von stark vorstrukturierten thermoplastischen Polymermaterialien, die mithilfe der lonenspurtechnologie erzeugt worden sind, abgebildet.

Die Struktur besteht aus dem thermoplastischen Polymermaterial, wobei sie mit einer stochastisch erzeugten Oberflächentopographie mit strukturellen Komponenten, den Strukturelementen, deren Abmessungen mindestens in einer Dimension, wie Länge, Breite, Höhe und/oder Durchmesser, im Nanometerbereich liegen können, also nanoskalig sein können, bedeckt ist. Unter Nanobereich bzw. Nanometerbereich soll im Rahmen der vorliegenden Erfindung der nanoskalige Bereich, vorzugsweise ein Bereich zwischen 5 bis 50 nm, verstanden werden. Es besteht aber auch die Möglichkeit, dass alle Dimensionsgrößen, wie Länge, Breite, Höhe und/oder Durchmesser, im grobskaligen Bereich liegen. Unter grobskalig wird der Größenbereich größer 100 Nanometern verstanden.

Schwach oder gering vorstrukturierte Oberflächenprofile unterscheiden sich demnach von stark vorstrukturierten Profilen nicht in ihren absoluten Größen, sondern durch die spezielle Form der Oberflächenstrukturierung. So zeichnen sich stark strukturierte Oberflächenprofile durch ein ausgeprägtes Tiefenrelief aus, das sich aus signifikanten Strukturelementen zusammensetzt, d.h. stark vorstrukturierte Oberflächenprofile zeichnen sich durch Komponenten aus, die mit einer stark ausgeprägten Schroff- bzw. Steilheit verbunden sind, während sich ein schwach oder gering vorstrukturiertes Oberflächenprofil eher als hügelig mit sanfteren Übergängen vorgestellt werden muss.

Die stark vorstrukturierte Oberfläche bzw. die erzeugten oberflächenstrukturierten Bereiche des thermoplastischen Polymers werden in einem sich anschließenden Prozess vakuumtechnisch oder chemisch bzw. elektrochemisch aktiviert und mit dem aufzubringenden anderen Material beschichtet, wobei der Schichtauftrag in einem ersten Prozessschritt nur wenige Atom- bzw. Moleküllagen beträgt. Dabei ist die Oberfläche durch wenige Monolagen des aufzubringenden Materials partiell bedeckt und die aufgebrachte Schicht der Oberflächenmorphologie hat sich angepasst und umfasst damit einen nanoskaligen Schichtdickenbereich. Das heißt, die Beschichtung wird in der Form ausgeführt, dass die Oberfläche des Festkörpers des thermoplastischen Polymers noch nicht vollständig mit dem aufzubringenden Material überzogen ist, so dass sich noch keine flächendeckende Schicht, bezogen auf die insgesamt zur Verfügung stehende freie Oberfläche des thermoplastischen Polymers, ausgebildet hat.

Der Oberflächen- und der oberflächennahe Festkörperbereich des thermoplastischen Polymers wird in dieser alternativen Ausführungsform mit der aufgebrachten Schicht des anderen Materials in einem vorgegebenen Zeitintervall, d.h. impulsartig mit einer Impulsdauer im Bereich von 1 ms bis 100 s, durch Wärmezufuhr beeinflusst, wobei die Temperatur der Wärmequelle bis zu 500 K oberhalb der Schmelztemperatur des Polymermaterials liegt, so dass der Betrag der einzubringenden Wärmemenge dergestalt dimensioniert wird, dass vornehmlich in den Strukturelementen der Oberflächenstrukturierung des Substratmaterials, die sich auf der Festkörperoberfläche befinden und den oberflächennahen Bereich darstellen, die Formänderungsfähigkeit zunimmt, bis sie beginnen zu fließen und in der Form in das Polymermaterial einsinken, dass das Polymermaterial des Substrates die aufgebrachte Schichtstruktur vollständig bzw. nahezu vollständig umschließt und die vorhandenen Freiräume auffüllt.

In einer anderen Variante der oben genannten alternativen Ausführungsform wird der Oberflächen- und der oberflächennahe Festkörperbereich des thermoplastischen Polymers mit der aufgebrachten Schicht des anderen Materials in einem vorgegebenen Zeitintervall, d.h. impulsartig mit einer Impulsdauer im Bereich von 1 ms bis 100 s, durch Wärmezufuhr beeinflusst, wobei die Temperatur der Wärmequelle bis zu 500 K oberhalb der Schmelztemperatur des Polymermaterials liegt, und auf diese Schicht ein Druck, also eine Kraft pro Fläche, der im Bereich zwischen 10 % und 150 % der Zugfestigkeit des Polymermaterials liegt, ausgeübt. Dabei wird der Betrag der einzubringenden Wärmemenge und der Druck dergestalt dimensioniert, dass vornehmlich in den Strukturelementen der Oberflächenstrukturierung des Substratmaterials, die sich auf der Festkörperoberfläche befinden und den oberflächennahen Bereich darstellen, die Formänderungsfähigkeit des Polymermaterials zunimmt, bis sie beginnen zu fließen und in der Form einsinken, dass das Polymermaterial des Substrates die aufgebrachte Schichtstruktur vollständig bzw. nahezu vollständig umschließt und die vorhandenen Freiräume auffüllt.

Vorzugsweise wird die in dieser Ausgestaltung der Erfindung vorgesehene starke Vorstrukturierung der Oberfläche, insbesondere bei thermoplastischen Fluorpolymermaterialien, durch Bearbeitung mit energetischen Schwerionen erzielt. Eine starke Vorstrukturierung der Oberfläche kann aber auch durch Methoden der lonenspurtechnologie oder durch andere alternative Oberflächenbearbeitungsmethoden erzielt worden sein.

Zur Erzeugung einer starken Vorstrukturierung von Fluorpolymeren werden energetische Schwerionen, deren Energiebereich zwischen 1,5 keV und 10 keV liegt, bei einem Arbeitsdruck von 1×10⁻⁴ bis 1×10⁻³ mbar eingesetzt. Die energetischen Schwerionen können zum Beispiel aus den Elementen Stickstoff, N₂, Sauerstoff, O₂, Fluor, F₂, Chlor, Cl₂, und deren Verbindungen sowie den Edelgasen, Neon, Ne, Argon, Ar, Krypton, Kr, Xenon, Xe, erzeugt werden.

Zur Erzeugung einer starken Vorstrukturierung mit thermoplastischen Polymeren auf der Grundlage der lonenspurtechnologie werden die Polymerfolien mit energiereichen Schwerionen, in der Regel mit den Edelgasionen Argon, Ar, Krypton, Kr, oder Xenon, Xe, bestrahlt. Die Oberflächenprofiltiefe der Strukturelemente der thermoplastischen Polymere mit einer starken Vorstrukturierung korreliert mit der Reichweite der eindringenden energiereichen Schwerionen. Aus diesem Grund liegt der Energiebereich dieser Ionen zwischen 0,5 und 1 MeV/amu (amu = atomic mass unit). Die x- bzw. y-, bzw. die radiale Ausdehnung der in einem Ätzprozess auszubildenden Strukturelemente korreliert mit der Bestrahlungsdichte, die zwischen 5 × 10⁵ Ionen/cm² und 1 × 10⁹ Ionen/cm² liegt. Nach der Bestrahlung werden die Folien geätzt, wobei für jeden Folientyp ein spezielles Ätzmittel zum Einsatz kommt. Werden z.B. Polyesterfolien mit energiereichen Schwerionen bestrahlt, dann wird im Anschluss daran die Folie in einer 2- bis 7-normalen Natriumhydroxidlösung in einem Temperaturbereich von 20 °C bis 70 °C etwa 5 bis 20 Minuten lang geätzt.

Durch die erfindungsgemäße spezielle thermische Oberflächenbehandlung wird unter Ausnutzung des Fließverhaltens thermoplastischer Polymere nunmehr in beiden Fällen, das heißt mit oder ohne starke Vorstrukturierung, das andere Material in den oberflächennahen Festkörperbereich eingebettet und dadurch mit dem Substratmaterial verankert. In einem sich anschließenden Oberflächenbearbeitungsprozess werden die Bereiche des anderen Materials, die sich direkt in unmittelbarer Nähe der Oberfläche befinden, freigelegt und aktiviert. Die gesamte Oberfläche wird nunmehr mit dem anderen Material beschichtet. Auf diese Weise bildet sich ein Komposit mit einem haftfesten Verbund zwischen den beiden unterschiedlichen Materialien, also dem thermoplastischen Polymer und dem anderen Material, heraus. Vorteilhaft erfolgt in den möglichen Ausführungsformen der Erfindung die Anfangsbeschichtung der thermoplastischen Substratoberfläche durch vakuumtechnische Methoden. Die Anfangsbeschichtung der thermoplastischen Substratoberfläche kann allerdings auch durch chemische und elektrochemische Methoden erfolgen.

Vorzugsweise ist in den möglichen Ausführungsformen der Erfindung das aufgebrachte Material ein leitfähiges Material. Das mit dem aufzubringenden leitfähigen Material beschichtete Substrat wird gemäß einer Ausführungsvariante einer Mikrowellenstrahlung ausgesetzt, wobei die Mikrowellenenergie in der Form ausgelegt ist, dass die dadurch von dem leitfähigen Material absorbierte Wärmeleistung genau so groß wird, dass nur die Zonen des Polymermaterials, die unmittelbar mit dem aufgebrachten Material in Kontakt stehen, eine Wärmeabgabe in der Form erfahren, dass sie beginnen, so zu fließen, dass die Schichtstrukturen des aufzubringenden Materials in das Polymermaterial vollständig bzw. nahezu vollständig einsinken und eventuell vorhandene Freiräume auffüllen. Für eine mit mehreren Atomlagen metallisierte Polymerfolie lässt sich für die Bestrahlung mit einem 2,45 GHz-Magnetron angeben, dass die Bestrahlungsleistung im Bereich zwischen 1 Ws/cm² bis 10000 Ws/cm² bei einer Expositionszeit zwischen 0,1 s bis 150 s liegt. Zur Optimierung des Wärmeeintrages kann die Mikrowellenbestrahlungsleistung auch mittels Impulsfolgen zugeführt werden. Die Impulsbreiten liegen dabei im Bereich von 0,01 s bis zu mehreren Sekunden.

Gemäß einer anderen Ausführungsvariante wird das mit einem aufzubringenden leitfähigen Material beschichtete Substrat einer Mikrowellenstrahlung ausgesetzt und auf die Oberfläche ein Druck, also eine Kraft pro Fläche, der im Bereich zwischen 10 % und 150 % der Zugfestigkeit des Polymermaterials liegt, ausgeübt, wobei die Mikrowellenenergie und der Druck in der Form ausgelegt sind, dass die dadurch von dem leitfähigen Material absorbierte Wärmeleistung und der Druck genau so groß werden, dass nur die Zonen des Polymermaterials, die unmittelbar mit dem aufgebrachten Material in Kontakt stehen, eine Wärmeabgabe in der Form erfahren, dass sie beginnen, so zu fließen, dass die Schichtstrukturen des aufzubringenden Materials in das Polymermaterial vollständig bzw. nahezu vollständig einsinken und eventuell vorhandene Freiräume auffüllen. Für eine mit mehreren Atomlagen metallisierte Polymerfolie lässt sich für die Bestrahlung mit einem 2,45 GHz-Magnetron angeben, dass die Bestrahlungsleistung im Bereich zwischen 1 Ws/cm² bis 10000 Ws/cm² bei einer Expositionszeit zwischen 0,1 s bis 150 s liegt. Zur Optimierung des Wärmeeintrages kann die Mikrowellenbestrahlungsleistung auch mittels Impulsfolgen zugeführt werden. Die Impulsbreiten liegen dabei im Bereich von 0,01 s bis zu mehreren Sekunden.

Der bevorzugte Energiebereich für die zur Freilegung des Oberflächenbereiches der in das Polymermaterial eingesunkenen Schichtstrukturen des aufgebrachten Materials und zur Aktivierung des freigelegten Oberflächenbereiches verwendeten energetischen Schwerionen liegt zwischen 1,5 keV und 10 keV. Die energetischen Schwerionen können zum Beispiel aus den Elementen Stickstoff, N₂, Sauerstoff, O₂, Fluor, F₂, Chlor, Cl₂, und deren Verbindungen, sowie den Edelgasen, Neon, Ne, Argon, Ar, Krypton, Kr, Xenon, Xe, erzeugt werden.

Die Anschlussbeschichtung der thermoplastischen Substratoberfläche kann durch vakuumtechnische Methoden erfolgen, aber auch durch chemische und elektrochemische Methoden sowie durch eine Kombination aus vakuumtechnischen und chemischen und elektrochemischen Methoden.

Ein weiterer Vorteil der Erfindung betrifft jeden haftfesten Verbund eines Substratmaterials, bestehend aus einem thermoplastischen Kunststoff mit einer unbehandelten oder einer zur Erzielung einer Vorstrukturierung behandelten Oberfläche mit einem anderen Material, der durch das oben beschriebene erfindungsgemäße Verfahren bzw. durch eines der oben genannten Ausführungsformen des Verfahrens erhältlich ist.

Mit dem erfindungsgemäßen Verfahren ist ein haftfester Verbund mit extrem kleinem Übergangsbereich, das heißt dem Bereich, in dem sich sowohl thermoplastische Komponenten als auch Komponenten des aufgebrachten Materials befinden, erzeugbar, der sich außerdem dadurch auszeichnet, dass keine Freiräume in der Übergangszone zwischen dem thermoplastischen Material und dem aufzubringenden Material vorhanden sind. Der Übergangsbereich hat in der Regel eine nanoskalige Schichtdickenausdehnung. Ein weiterer Vorteil dieses Verbundes besteht darin, dass die Oberfläche durch den Fließprozess der thermoplastischen Komponente eingeebnet worden und damit geglättet ist, was für Folgebearbeitungsprozesse, die in der Regel für die weitere Funktionalisierung des Verbundmaterials von Bedeutung sind, einen großen Vorteil darstellen kann.

Besonders wichtig ist jedoch die Tatsache, dass sich im direkten Interface-Bereich, also dem Bereich, in dem sich Komponenten des thermoplastischen und des aufzubringenden Materials berühren, und somit im Übergangsbereich keine Freiräume, das heißt keine kleinsten freien Volumina befinden, die sich insbesondere bei Folgebearbeitungsprozessen nachteilig auf die Verbundeigenschaften des entstandenen Komposits auswirken können. Dadurch, dass die Komponenten vollständig, also total, in das Polymermaterial "eingebettet" worden sind, existiert auch keine Möglichkeit mehr, diese Agenzien von außen her zu beeinflussen. Aus diesem Grund ist die Wahrscheinlichkeit der Verschlechterung der Verbundeigenschaften durch Alterungsprozesse außerordentlich stark reduziert, weil diese quasi nicht stattfinden können.

Weitere Einzelheiten, Merkmale und Vorteile der Erfindung ergeben sich aus der nachfolgenden Beschreibung von Ausführungsbeispielen mit Bezugnahme auf die zugehörigen Zeichnungen. Es zeigen:
- **Figur 1:**: Rasterelektronenmikroskop-Aufnahmen verschiedener Oberflächenmorphologien; Stand der Technik, wobei a) Rasterelektronenmikroskopaufnahmen von stark vorstrukturierten Fluorpolymermaterialien zeigt, die durch die Oberflächenbearbeitung mit energetischen Schwerionen erzeugt worden sind, b) Rasterelektronenmikroskopaufnahmen von stark vorstrukturierten thermoplastischen Polymermaterialienzeigt, die mithilfe der lonenspurtechnologie erzeugt worden sind, und c) eine schematische Darstellung der jeweiligen einzelnen Strukturelemente zeigt;
- **Figur 2:**: Eine schematische Schnittdarstellung von mit dem aufzubringenden Material in einer nanoskaligen Schichtdicke beschichteten Strukturelementen; Stand der Technik, wobei a) ein detailliertes Einzelobjekt und b) auf einem Substrat aufgereihte Einzelobjekte zeigt;
- **Figur 3:**: Eine schematische Schnittdarstellung eines durch chemische Metallschichtabscheidung in einer nanoskaligen Schichtdicke beschichteten Ensembles von Strukturelementen mit
- **Figuren 4a-c:**: geschlossener Metallschicht und noch vorhandenen Freiräumen; Stand der Technik. Schematische Schnittdarstellungen der Beeinflussung der mit einem aufzubringenden Material beschichteten Polymeroberfläche durch eine Wärme- bzw. eine simultane Wärme- und Druckbehandlung, mit a) anfänglich großen Hohlräumen, die b) zusehends kleiner werden, bis sie c) ganz verschwinden.
- **Figuren 5a, b:**: Schematische Schnittdarstellungen des Zustandes nach der Beeinflussung des Komposits durch eine Wärme- bzw. eine simultane Wärme- und Druckbehandlung.
- **Figur 6:**: Rasterelektronenmikroskop-Aufnahmen verschiedener Polymeroberflächenmodifikationen.
- **Figur 7:**: Transmissionelektronenmikroskop-Aufnahmen verschiedener Metallcluster auf verschiedenen Polymeren **[J. Faupel, Dissertation: "Wachstum von metallischen Nanoclustern auf Polymeroberflächen", Göttingen, 2005, a)** **Abb. 5****.****2** **(4), b)** **Abb. 5****.27 (3), c)** **Abb. 5****.32 (2), d)** **Abb. 5****.33 (4)].**
- **Figur 8:**: Transmissionelektronenmikroskop-Aufnahmen von Palladium auf Polycarbonat und auf Polymethylmethacrylat **[J. Faupel, Dissertation: "Wachstum von metallischen Nanoclustern auf Polymeroberflächen", Göttingen, 2005, a)** **Abb. 5****.32 (1), b)** **Abb. 5****.32 (2), c)** **Abb. 5****.32 (3), d)** **Abb. 5****.33 (2), e)** **Abb. 5****.33 (3), f)** **Abb. 5****.33 (4)].**
- **Figuren 9a-c:**: Schematische Schnittdarstellungen der Beeinflussung der mit einem aufzubringenden Material beschichteten Polymeroberfläche, die unbehandelt oder gering vorbehandelt beziehungsweise strukturiert ist, durch eine Wärme- bzw. eine simultane Wärme- und Druckbehandlung.
- **Figur 10:**: Eine schematische Schnittdarstellung der Oberflächenbearbeitung des Komposits, bestehend aus thermoplastischen Komponenten des Trägermaterials und der aufgebrachten Schicht, im unmittelbaren Oberflächenbereich mit energetischen Schwerionen.
- **Figuren 11a, b:**: Schematische Schnittdarstellungen der Oberfläche des Komposits nach der Bearbeitung mit energetischen Schwerionen und
- **Figuren 12a, b:**: Schematische Schnittdarstellungen der Schichtverstärkung des aufgebrachten Materials, nachdem die Komponenten des aufgebrachten Materials partiell durch einen Bearbeitungsprozess mit energetischen Schwerionen freigelegt worden sind.

Zur Charakterisierung von Oberflächen existieren verschiedene Analysemethoden. Die einzelnen analytischen Techniken unterscheiden sich durch ihren Informationsgehalt bezüglich der erfassbaren geometrischen Abmaße und der chemischen Zusammensetzung, die Anforderungen an das zu untersuchende System und den zur Durchführung einer Analyse erforderlichen Aufwand. Die am häufigsten eingesetzten Methoden lassen sich in folgende Kategorien einteilen:
- Optische Erfassung der Oberflächenbeschaffenheit,
- Charakterisierung der chemischen Zusammensetzung der Oberfläche oder des oberflächennahen Festkörpervolumens,
- Charakterisierung der Oberflächentopographie.

Die **Tabelle 1** zeigt einen Überblick über analytische Techniken in der Oberflächen- und Nanoanalytik, die Stand der Technik sind. Diese Techniken sind beispielsweise auch auf der Internetseite http://www.tascon.eu/de/ analytischer-service/analysemethoden/uebersicht/abkuerzungen.php aufgeführt. In **Tabelle** 1 sind wesentliche Methoden für die Charakterisierung der Topographie von Festkörperoberflächen grafisch dargestellt, wobei unter bestimmten Bedingungen auch Strukturelemente, die Gegenstand der vorliegenden Erfindung (vgl. Figur 1) sind, abgebildet werden können. Die quasi beste Methode, derartige Oberflächenstrukturen darzustellen, ist die Rasterelektronenmikroskopaufnahme (REM-Aufnahme).

**Tabelle 1**

| **Methode** | **Abkürzung** |
|---|---|
| Niederenergetische Ionenbeugung; | LEIS |
| Röntgen- Photoelektronenspektroskopie; | |
| Rasterkraftmikroskopie; | AFM |
| Rasterelektronenmikroskopie; | SEM; deutsch REM |
| Transmissionelektronenmikroskopie; | TEM |
| Abgeschwächte Totalreflexion mit Fourier- | ATR-FTIR |
| Transformationsinfrarotspektroskopie; | |
| Sekundärionenmassenspektrometrie; | ToF-SIMS |
| Schneller Ionen-Beschuss (Focused Ion Beam); | FIB |
| Augerelektronenspektroskopie; | AES |
| Energiedispersive Röntgenstrahlspektroskopie; | EDX |
| Mikro-Raman-Spektroskopie; | µ_{Raman} |
| Röntgenfluoreszenzspektrometrie; | XRF |
| Röntgenbeugung; | XRD |
| Induktiv gekoppelte plasmainduzierte Massen- | LA-ICP-MS |
| spektrometrie mit Laserablation; | |
| Atomsonde (Atom-Probe) | AP |
| Helium-Ionen-Mikroskopie | He IM |

In der **Figur 1** sind Rasterelektronenmikroskopaufnahmen (REM-Aufnahmen) verschiedener Oberflächenmorphologien, deren Strukturen bzw Strukturelemente aus dem oberflächennahen Festkörperbereich thermoplastischer Polymerfolien herausgearbeitet worden sind, dargestellt. Insbesondere zeigen diese REM-Aufnahmen Oberflächenmorphologien, deren Strukturelemente einem fädchenartigen 1, fraktalen 2 bzw. säulenartigen 3 Strukturtyp zugeordnet werden können. Zum einen sind die gezeigten Strukturen durch direkten Beschuss der ursprünglichen Oberfläche mit energetischen Schwerionen in einem Energiebereich der Ionen von 0,5 bis 8 keV erzeugt worden, wobei die **Figur 1** in **a)** eine entsprechende, durch die Bearbeitung mit energetischen Ionen erzeugte Oberflächenstrukturierung zeigt. Zum anderen sind die Strukturen durch die lonenspurtechnologie, das heißt durch Bestrahlung des Festkörpers mit hochenergetischen Schwerionen in einem Energiebereich der Ionen von 0,1 bis 1,5 MeV/amu und anschließender chemischer Ätzung, erzeugt worden, wobei die **Figur 1** in **b)** eine entsprechende Oberflächenstrukturierung, die durch die Anwendung der lonenspurtechnologie erzeugt worden ist, zeigt.

Aus der **Figur 1** ist ersichtlich, dass sich die Strukturformen grundsätzlich ähneln. Es ist außerdem zu erkennen, dass sich die gesamte Oberflächenstruktur als eine Zusammensetzung von Strukturelementen 1, 2 bzw. 3, die in **Figur 1** in c) schematisch dargestellt sind, auffassen lässt. Diese Strukturelemente 1, 2 bzw. 3 lassen sich in verschiedene Typen einteilen, zum Beispiel in einen fädchenartigen Strukturtyp 1, in einen fraktalen bzw. hochgebirgsartigen bzw. stark zerklüfteten Strukturtyp 2 oder in einen säulenartigen Strukturtyp 3, wobei diese Einteilung genaugenommen willkürlich ist und es auch keine scharfe Abgrenzung zwischen diesen einzelnen gewissermaßen beliebig festgelegten Elementformen, sondern einen fließenden Übergang gibt. Dennoch hilft diese Abstraktion, also die stilistische Reduzierung der Oberflächenstruktur auf die schematisch dargestellten Strukturelemente 1, 2 bzw. 3, den der Erfindung zugrunde liegenden Gegenstand anschaulich zu erklären.

Um die in **Figur 1** abgebildeten Strukturelemente 1, 2 bzw. 3, die die Oberfläche der Polymere darstellen, noch detaillierter charakterisieren zu können, sollen zusätzlich die gemittelte Rautiefe R_{Z} und die maximale Rautiefe Rₘₐₓ herangezogen werden.

Dabei entspricht R_{Z}, die gemittelte Rautiefe, nach DIN 4768 (1990-05) dem arithmetischen Mittel der fünf Einzelrautiefen Zᵢ, das heißt im speziell vorliegenden Fall, den Tiefen einzelner Strukturelemente 1, 2 bzw. 3 von fünf aufeinanderfolgenden Einzelmessstrecken Iᵢ. Dabei ist die Einzelrautiefe Zᵢ der Abstand zweier Parallelen zur mittleren Linie, die innerhalb der Einzelmessstrecke das Rauheitsprofil am höchsten oder am tiefsten Punkt berühren.

Nach DIN 4768 (1990-05) ist Rₘₐₓ die größte der auf der Gesamtmessstrecke Iₘ vorkommenden Einzelrautiefen Zᵢ. Sowohl die gemittelte als auch die maximale Rautiefe liegen für die in dieser Schrift betrachteten Strukturelemente 1, 2 bzw. 3 zwischen 100 nm und maximal 10 µm. Darüber hinaus lässt sich noch ein weiterer Parameter zur Charakterisierung der Oberflächenstruktur heranziehen, nämlich das Aspektverhältnis, das dem Verhältnis zwischen der Höhe der Strukturelemente 1, 2 bzw. 3 (siehe R_{Z} beziehungsweise Rₘₐₓ) und der Breite der Strukturelemente 1, 2 bzw. 3 entspricht, wobei im speziellen Fall der Wert für die Breite aus dem oberen Drittel eines Strukturelementes 1, 2 bzw. 3, also dem Bereich, in dem sich das einzelne Strukturelement 1, 2 bzw. 3 klar herausbildet, entnommen werden muss. Das Aspektverhältnis ist in diesem Fall mindestens größer als 3 : 1. Von nanoskaligen Oberflächenstrukturen kann in diesem Fall dann gesprochen werden, wenn diese mindestens in einer Raumrichtung Abmessungen von weniger als 100 nm aufweisen. Aus diesem Grund wird für "Kleinstrukturen", also Strukturelemente 1, 2 bzw. 3, die diese Bedingung erfüllen, der Begriff "Nanostruktur" verwendet. Entsprechend größere "Kleinstrukturen" (also Strukturelemente) werden hier als "Mikrostruktur" bezeichnet. Obwohl mit der Einführung des Begriffes "Strukturelement" in gewisser Hinsicht eine ordnende Komponente eingeführt worden ist, soll noch einmal erwähnt sein, dass die hier betrachteten Strukturen einer sogenannten stochastischen Oberflächentopographie entsprechen. Bei der Generierung derartiger Strukturen lassen sich prinzipiell nur statistische Parameter gezielt beeinflussen. Oberflächenprofile mit einer dementsprechenden Strukturform werden im Folgenden als "stark vorstrukturierte Oberfläche" bezeichnet.

In den oben erwähnten Schriften und Publikationen werden die erzeugten Strukturen, also die Strukturelemente, beschichtet, zum Beispiel metallisiert. Die Beschichtung erfolgt in der Form, dass sich das durch Beschichtungsverfahren im Vakuum aufgebrachte Material der Oberflächenmorphologie der Strukturelemente, das heißt den dreidimensionalen Strukturformen der Elemente, so gut wie möglich anpasst.

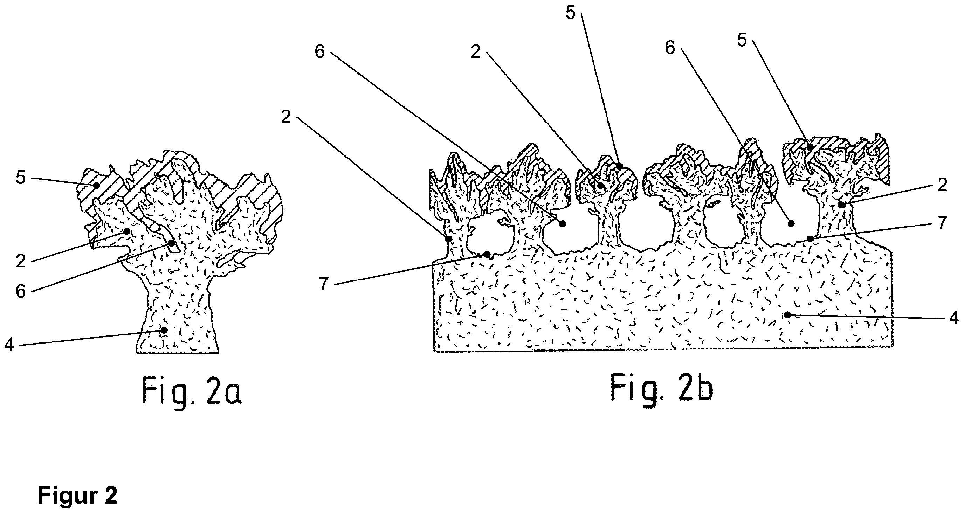

In der **Figur 2** ist der Schnitt durch einen Festkörper aus einem thermoplastischen Trägermaterial 4 mit einem beschichteten Strukturelement 2, siehe **a)**, bzw. mit einer Gruppe von beschichteten Strukturelementen 2, siehe **b)**, schematisch dargestellt. Die Strukturelemente 2 sind in einer nanoskaligen Schichtdicke mit dem aufzubringenden Material 5 beschichtet. Das Beschichtungsverfahren wird derart ausgeführt, dass sich das aufgebrachte Material 5 entsprechend gut an die vorhandene Oberflächenmorphologie anpasst. Dennoch bleiben unbeschichtete Zonen in Form von freien Volumina 6 übrig.

Für **Figur 2** sind dafür Strukturelemente 2 vom fraktalen Strukturtyp 2 ausgewählt worden. Aber auch bei den anderen Strukturelementtypen, dem fädchenartigen 1 und dem säulenartigen 3 Strukturtyp, stellen sich bei der gleichen Vorgehensweise analoge Bedingungen ein. Die schematischen Darstellungen in **Figur 2** veranschaulichen jedoch die Tatsache, dass sich bei einem derartigen Beschichtungsvorgang nicht die gesamte Oberfläche und auch nicht der gesamte Raum mit der aufzubringenden Schicht 5 bzw. dem aufzubringenden Material 5 bedecken und auffüllen lässt. Die einzelnen Abmaße der Freiräume 6 bzw. Hohlräume 6 (Länge, Breite, Höhe) und der freien Flächenzonen 7 (Länge, Breite) liegen in der Regel im Nanometerbereich. Bei sehr großen Strukturelementen 2, das heißt, wenn deren Abmessungen (Höhe und/oder Breite) im µm-Bereich liegen, können dann auch die Abmaße der entstehenden Freiräume 6 und der freien Flächenzonen 7 im einstelligen Mikrometerbereich liegen. In **Figur 2** ist der Effekt lediglich schematisch und dabei übertrieben und nicht ganz dimensionskonform dargestellt. Die Darstellung widerspiegelt jedoch das bestehende Problem. Es bleiben nach dem Beschichtungsprozess freie Oberflächenbereiche 7 zurück, also Bereiche, die nicht mit der aufzubringenden Schicht 5 bzw. dem aufzubringenden Material 5 bedeckt worden sind. Auch sind in der Regel noch freie Hohlräume 6 vorhanden, also Volumenbereiche, die nicht vollständig mit dem Beschichtungsmaterial 5 aufgefüllt sind. Obwohl zum Beispiel im Falle des Gegenstands der bereits erwähnten DE 10 2004 011 567 A1 der haftfeste Verbund durch einen nanostrukturierten, Nanokomposite enthaltenden Übergangsbereich zwischen dem Substratmaterial und dem anderen Material gebildet wird, innerhalb dessen das Substratmaterial nanostrukturiert in das andere Material übergeht, werden auch hier nicht alle freien Oberflächenbereiche 7 vollständig mit der zweiten Schicht 5, also dem aufzubringenden Material 5, abgedeckt, so dass es auch in diesem Fall zu nicht abgedeckten bzw. nicht aufgefüllten Bereichen 6, 7 kommt. Das heißt, es bilden sich Regionen mit einer Ausdehnung von einigen Nanometern aus, in denen sich auch kein nanostrukturierter Übergangsbereich ausgebildet hat oder zumindest nicht in der Form, wie er sich in den umliegenden angrenzenden Bereichen ausbildet. Es soll noch einmal hervorgehoben werden, dass es sich hier um sehr kleine Inselbereiche mit kleinsten Ausdehnungen, also mit Abmaßen von einigen wenigen Nanometern handelt.

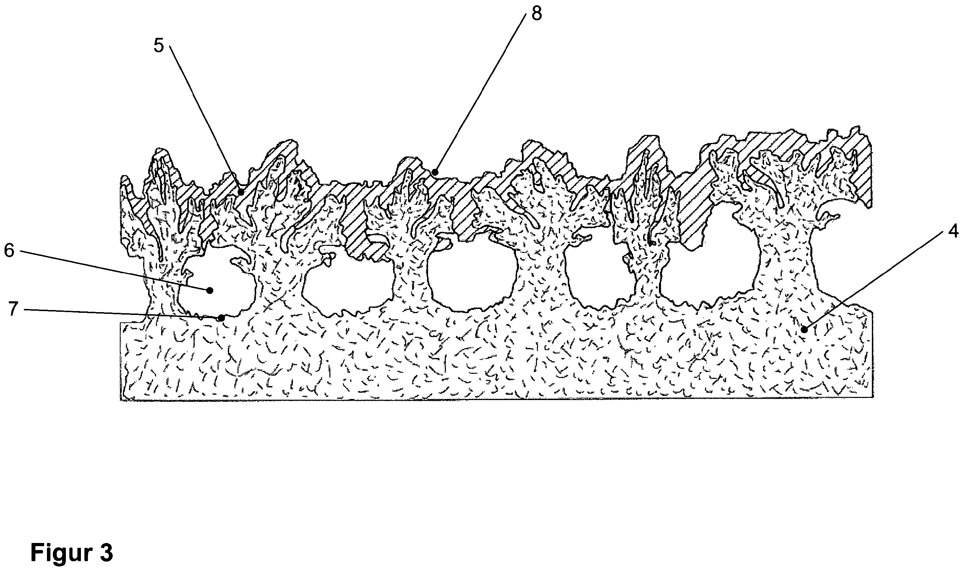

Selbst bei sogenannten chemischen Metallstartschichtaufträgen werden nicht alle frei liegenden Oberflächenbereiche 7 abgedeckt. In der Regel werden dafür Oberflächen von Isolatormaterialien bekeimt, zum Beispiel mit Palladiumkeimen oder mit leitfähigen Polymeren. Auf diesen auf die Oberfläche abgelegten und angebundenen Keimen wachsen dann aufgrund des elektrochemischen Potenzials Metallkristallite auf diesen Keimen auf. Aufgrund der Eigenschaft der bereits beschriebenen Oberflächenstrukturierung, also der speziellen Oberflächenmorphologie, führt der Beschichtungsprozess dazu, dass sich eine geschlossene Oberfläche 8 bildet, ohne dass bereits die gesamte vorhandene freie Oberfläche 7 des thermoplastischen Trägermaterials 4 und in diesem Zusammenhang vorhandenes freies Volumen 6 mit dem aufzubringenden Metall 5 abgedeckt bzw. aufgefüllt ist. Diese Besonderheit ist in **Figur 3** dargestellt, die eine schematische Schnittdarstellung eines durch chemische Metallschichtabscheidung in einer nanoskaligen Schichtdicke beschichteten Ensembles von Strukturelementen 2 mit geschlossener Metallschicht 5 und noch vorhandenen Freiräumen 6, das heißt freien Volumina 6, zeigt.

Bei direktem Kontakt mit wässrigen Lösungen dringt das flüssige Medium nach und nach in die noch vorhandenen Hohlräume 6 ein und wirkt dadurch auch auf bereits verbundene bzw. durch spezielle Bearbeitungsmethoden erzielte, gebundene Zonen, indem sich durch die wässrige Lösung die polaren und chemischen Verhältnisse im Interface-Bereich, also in dem Bereich, in dem sich Bestandteile des thermoplastischen Materials 4 und des Materials der aufzubringenden Schicht 5, insbesondere auch Metalle, befinden, verändern, wobei diese Veränderung auch eine Reduktion des Haftverbundes bedeuten. Bei besonders dünnen Schichten des aufzubringenden Materials 5, vorwiegend bei Metallen, vollzieht sich dieser Prozess verhältnismäßig schnell. Je größer die geschlossene Schichtdicke des aufgebrachten Stoffes 5 (Metalls) ist, um so länger ist die Zeitspanne, bis die wässrige Lösung in den Mikro- bzw. Nano-Hohlräumen 6 zur Wirkung kommt. Dennoch, ein Effekt tritt bei direktem Kontakt mit wässriger Lösung immer auf.

Wie bereits erwähnt, liegt der Erfindung das Problem eines haftfesten Verbundes zwischen einem thermoplastischen Substratmaterial 4 mit einem anderen Material 5 zugrunde sowie die Schaffung eines Verfahrens zur Herstellung eines entsprechenden haftfesten Verbundes, wobei die Nachteile des Standes der Technik vermieden werden sollen. Zur Lösung des vorhandenen und bereits beschriebenen Problems werden spezielle Eigenschaften des thermoplastischen Verhaltens der Polymermaterialien ausgenutzt. Bei einer erfindungsgemäßen ersten Methode wird von einem thermoplastischen Material 4 mit einer bereits stark vorstrukturierten Oberfläche, wie sie zum Beispiel in **Figur 1** dargestellt ist, ausgegangen. Diese Oberfläche wird in einem speziellen Beschichtungsverfahren durch wenige Monolagen des aufzubringenden Materials 5 partiell bedeckt, in dem diese Atomlagen in Summe einen nanoskaligen Schichtdickenbereich, das heißt einen Schichtdickenbereich von unter 100 nm, bevorzugt einen Schichtdickenbereich zwischen 5 und 50 nm, umfassen. Für die umfassende Wirkung des Effektes, der im Weiteren beschrieben wird, ist es von Vorteil, diese Beschichtung in der Form auszuführen, dass die Oberfläche 8 des Festkörpers 4 noch nicht vollständig mit dem aufzubringenden Material 5 überzogen ist, das heißt, dass sich noch keine flächendeckende Schicht bezogen auf die insgesamt zur Verfügung stehende freie Oberfläche 7 ausgebildet hat.

Da auch bzw. insbesondere die sich im Oberflächenbereich der Thermoplaste befindliche Strukturierung, die als eine Anreihung von Strukturelementen 1, 2 bzw. 3, siehe **Figur 1****,** zu verstehen ist, in ihrer molekularen Zusammensetzung keine erkennbare, sich wiederholende Ordnung aufweist, in der die einzelnen Teilchen, wie Moleküle, Atome und Ionen, angeordnet sind, haben auch sie wie die Thermoplaste an sich keinen Schmelzpunkt und gehen deshalb ebenfalls in einem bestimmten Temperaturbereich, der Glasübergangstemperatur des Thermoplasten, von der harten in eine flexible Phase über. Gekennzeichnet ist dieser Bereich somit auch bei den Strukturelementen 1, 2 bzw. 3 wie bei allen thermoplastischen Materialien dadurch, dass die Molekülketten in den Strukturelementen beweglich werden, ohne dass sich der Kunststoff, also das Strukturelement 1, 2 bzw. 3 direkt verflüssigt. Dies geschieht auch bei den Strukturelementen 1, 2 bzw. 3 erst bei weiter steigender Temperatur.

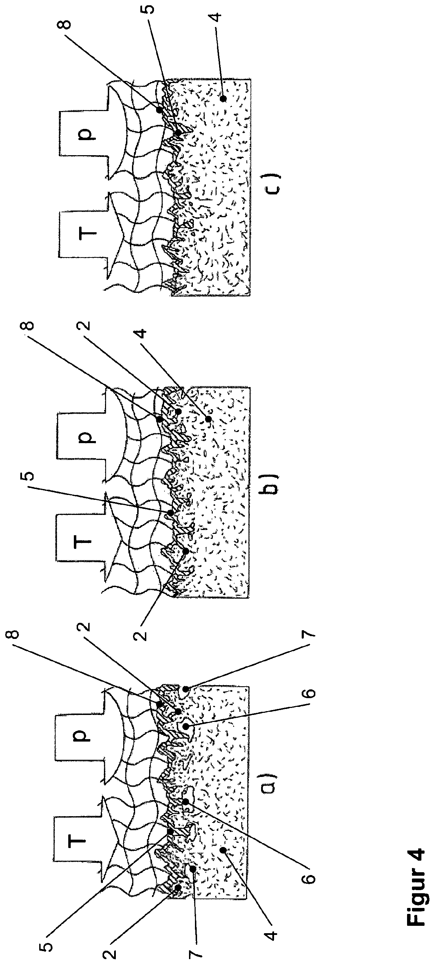

Gemäß der Konzeption der Erfindung wird dieser Effekt ausgenutzt, indem in die partiell mit einem anderen Material 5 beschichtete vorstrukturierte Oberfläche des zu bearbeitenden Materials 4 in einem vorgegebenen Zeitintervall, d.h. impulsartig mit einer Impulsdauer im Bereich von 1 ms bis 100 s, durch Wärmezufuhr beeinflusst, wobei die Temperatur der Wärmequelle bis zu 500 K oberhalb der Schmelztemperatur des Polymermaterials liegt, oder in einem vorgegebenen Zeitintervall, d.h. impulsartig mit einer Impulsdauer im Bereich von 1 ms bis 100 s, die Schicht durch Wärmezufuhr beeinflusst, wobei die Temperatur der Wärmequelle bis zu 500 K oberhalb der Schmelztemperatur des Polymermaterials 4 liegt, und auf diese Schicht ein Druck, also eine Kraft pro Fläche, der im Bereich zwischen 10 % und 150 % der Zugfestigkeit des Polymermaterials 4 liegt, ausgeübt wird. Dabei wird der Betrag der einzubringenden Wärmemenge und der Druck dergestalt dimensioniert, dass vornehmlich in den Strukturelementen 1, 2 bzw. 3, die sich auf der Festkörperoberfläche 8 befinden, die Formänderungsfähigkeit zunimmt, bis sie beginnen zu fließen, also die Fließtemperatur T_{f} bzw. die Kristallitschmelztemperatur Tₘ überschritten wird, das heißt sich der Übergang vom Glaszustand in den flüssigen Zustand vollzieht. Die **Figuren 4a** bis **4c** zeigen eine schematische Schnittdarstellung der Beeinflussung der mit einem aufzubringenden Material 5 beschichteten Oberfläche 8 des Polymers 4, die eine stochastische Ansammlung von Strukturelementen 2 darstellt, durch eine Wärme (T)- bzw. eine simultane Wärme (T)- und Druckbehandlung (p). Die Zeitdauer der Einwirkung ist so dimensioniert, dass sich der zu erzielende Effekt vollständig, siehe **Figur 4c****,** einstellen kann. Die **Figur 4a** zeigt in den Ausgangszustand zu Beginn der Behandlung. Die **Figur 4b** zeigt den Zustand, in dem die thermoplastischen Strukturelemente 2 zu fließen beginnen und die Freiräume 6, das heißt die freien Volumina 6, auffüllen. Die **Figur 4c** zeigt den Zustand, in dem Freiräume 6 aufgefüllt sind und die aufgebrachte Schicht 5 in das thermoplastische Polymer 4 eingebettet ist. Bildlich gesprochen, sacken die Strukturelemente 2 durch die Wärmezufuhr T und, wenn eingesetzt, den wirkenden Druck p in sich zusammen, das heißt, sie verteilen sich durch das aufgrund der Wirkung der Temperatur und, wenn eingesetzt, des Druckes verursachte Fließverhalten des Polymers 4 in die vorhandenen Freiräume 6, wie in den **Figuren 4a** bis **4c** gezeigt, und füllen diese Freiräume 6 nach und nach auf. Als vorteilhaft erweist sich der bei dieser Methode auftretende Effekt, dass mit steigender Temperaturerhöhung eine Abnahme der Viskosität verbunden ist, was bewirkt, dass die Kunststoffschmelze leichter fließt und somit in kleinste Hohlräume 6 eindringen kann.

Durch die damit im Zusammenhang stehende Verringerung des freien Volumens 6 zwischen den Strukturelementen 2 beginnt nun auch der kompakte oberflächennahe Festkörperbereich des Thermoplasten 4 entropieelastisch und schließlich sogar flüssig zu werden, wodurch durch die/den auf die Oberfläche wirkende/wirkenden Temperatur T/Druck p letztendlich der gesamte vorhandene Freiraum 6 mit flüssigem Polymer 4 aufgefüllt wird. Die oberflächenseitig applizierte Wärmezufuhr T und, wenn eingesetzt, der auf die Oberfläche wirkende Druck p müssen jedoch so dimensioniert sein, dass sich ihre grundsätzliche, das heißt die beschriebene, Wirkung nur auf die Strukturelemente 2 und den unmittelbar darunter liegenden kompakten Festkörperbereich 4 auswirkt, so dass sich im Inneren des Festkörperbereichs 4 genaugenommen keine prinzipielle Veränderung der Festkörperstruktur vollzieht bzw. vollziehen kann.

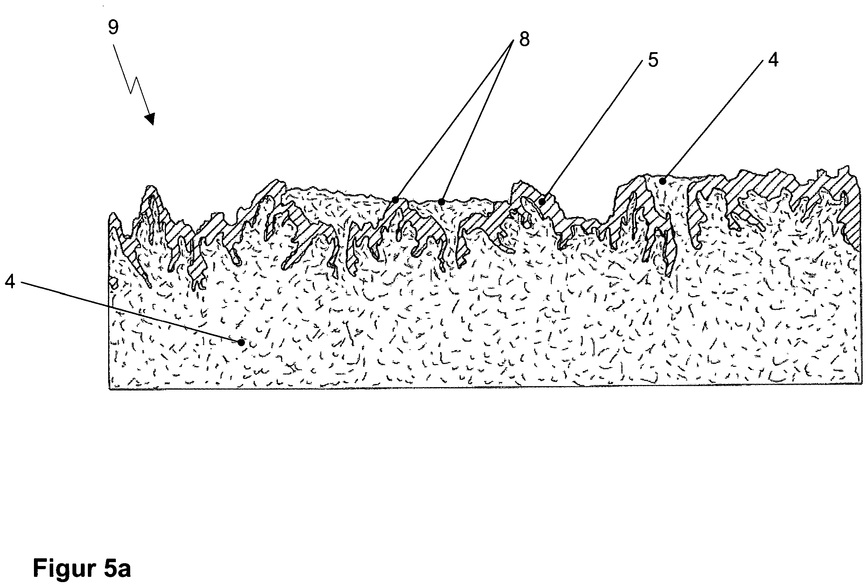

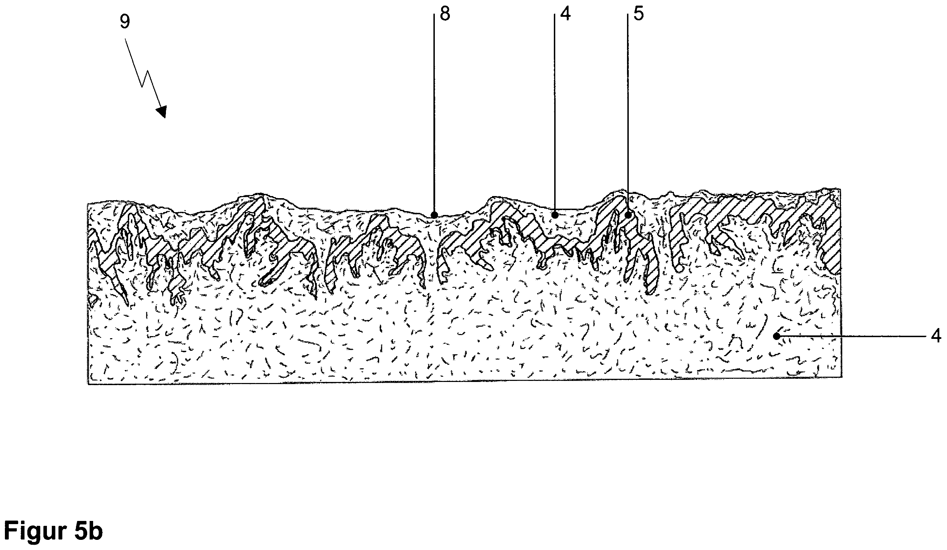

Die **Figuren 5a** und **5b** zeigen schematische Schnittdarstellungen des Zustandes nach der Beeinflussung des Komposits 9 durch eine Wärme- bzw. eine simultane Wärme- und Druckbehandlung. Dabei zeigt **Figur 5a** die Gesamtoberfläche 8 des Komposits 9, die teilweise aus thermoplastischen Komponenten des Trägermaterials 4 und teilweise aus aufgebrachtem Material 5 besteht. Die **Figur 5b** zeigt die gesamte Oberfläche 8 des Komposits 9, die nahezu vollständig aus thermoplastischen Komponenten des Trägermaterials 4 besteht. Mit der oben beschriebenen Vorgehensweise lässt sich das aufgebrachte Material 5 in die Oberfläche des thermoplastischen Festkörpers 4 einbetten, wie die **Figur 5a** zeigt. Im Extremfall kann sich eine Situation einstellen, die in **Figur 5b** schematisch dargestellt ist, nämlich die, dass das ursprünglich auf die Oberfläche partiell aufgebrachte Material 5 durch den beschriebenen thermoplastischen Fließprozess in den thermoplastischen Oberflächenbereich eingegraben wird, also nahezu vollständig umhüllt ist, das heißt, dass sich im Anschluss an den beschriebenen Prozess, also nach dem Abkühlen, auf der Oberfläche 8 des Komposits 9 primär thermoplastische Polymerkomponenten des Trägermaterials 4 befinden. Um die beschriebene Methode erfolgreich realisieren zu können, muss die Schmelztemperatur des auf die vorstrukturierte Oberfläche 8 des thermoplastischen Festkörpers 4 aufzubringenden Materials 5 größer sein als die des Thermoplasten 4. Insbesondere ist diese Methode für Metalle, das heißt, dass das aufzubringende Material 5 ein Metall ist, geeignet. Prinzipiell kann dafür jedes beliebige Metall verwendet werden, wenn dessen Schmelztemperatur höher ist als die des Thermoplasten 4.

Eine zweite bevorzugte Methode geht von speziellen thermoplastischen Ausgangsmaterialien aus, die sich dadurch auszeichnen, im geschmolzenen Zustand hinreichend gute Fließeigenschaften zu besitzen.

In vielen technischen Anwendungen werden in thermoplastische Materialien Füllstoffe zur Optimierung des Eigenschaftsprofils von Kunststoffen eingesetzt. Es handelt sich hierbei nicht mehr um reine Kunststoffe, sondern um "gefüllte" Polymere. Dabei sind die Füllstoffe Zusatzstoffe (Additive), die das Volumen eines Stoffgemisches erhöhen, meist jedoch, ohne die wesentlichen Eigenschaften der Polymers zu ändern. In den Thermoplasten, die in technischen Anwendungen eingesetzt werden, sind Partikelgröße, Partikelform, Partikelstruktur, Korngrößenverteilung, Größe der spezifischen Oberfläche und Oberflächenaktivität eines Füllstoffs entscheidende Faktoren für die Eigenschaften des Gemischs, dessen Weiterverarbeitung und die Eigenschaften des Endwerkstoffes. Durch Änderungen in den Füllstoffen können völlig verschiedene Resultate erzielt werden. In der Kunststofftechnik werden Füllstoffe zur Optimierung des Eigenschaftsprofils von Polymeren eingesetzt. Die Einarbeitung erfolgt in der Regel durch eine Compoundierung. Im Vordergrund der Compoundierung mit Füllstoffen steht häufig die Optimierung und Erhöhung der Steifigkeit, Verminderung der Schrumpfung und Verbesserung der Oberflächenanmutung. Weiter ist auch eine gezielte Erhöhung der thermischen oder elektrischen Leitfähigkeit möglich. Füllstoffe und Polymermatrix müssen dabei durch chemische Bindungen oder zwischenmolekulare Kräfte möglichst fest miteinander verbunden werden. Ein Kunststoffcompound ist eine Fertigmischung, die meistens ohne Zusatz verarbeitet werden kann.

Additivbatches sind in diesem Zusammenhang diejenigen Stoffe, die mit chemischen Substanzen gefüllt sind, um damit die Eigenschaften des Kunststoffes zu verändern, beispielsweise mit Gleitmitteln oder Antiblocks, beides Produkte, die in der Folienindustrie Anwendung finden. Additive können somit fest, flüssig oder in Monomeren gelöst sein. Die Additive werden neben den Füllstoffen in kleinen Mengen beigegeben, beeinflussen mechanische oder nicht mechanische Eigenschaften und stabilisieren die Monomere oder Polymere.

Wichtige Füllstoffe von thermoplastischen Kunststoffen sind zum Beispiel:
- Fasern: Glas, andere Polymere wie Polyester, Kohlenstofffasern, insbesondere Kurzfasern;
- Körper: Glaskugeln und Glasbruch;
- mineralische Füllstoffe: wie Bornitrid, zum Beispiel hexagonales Bornitrid, Calciumcarbonat und Talkum oder Schichtsilikate;
- Gewebe: Glas, andere Kunststoffe, wie Polyester;
- Whiskers: anorganische Stoffe in fadenförmigen Einkristallen;
- Pulver: Metalle, Holzmehl, Ruß, Graphit.

Beispiele für Additive sind:
- Weichmacher: Verändern mechanische Eigenschaften;
- Gleitmittel: Vereinfachen der Verarbeitung;
- Antioxidantien oder UV-Filter: Schutz vor Alterungsprozessen;
- Antistatika, Brandhemmer, Treibmittel, Farbstoffe: Erzeugung besonderer Produkteigenschaften.

Es ist allgemein bekannt, dass Füllstoffe in Kunststoffen sowohl zur Modifizierung der Eigenschaften als auch zur Kostenreduktion eingebracht werden. Diese Füllstoffe können sowohl hinsichtlich ihrer Teilchengröße grobskalig als auch nanoskalig sein.

Thermoplastische Kunststoffe, die anorganische Materialien als Füllstoffe enthalten, lassen sich in unzähligen Beispielen des Alltags wiederfinden. Diese Füllstoffe werden meist in hohem prozentualen Anteil dem polymeren Grundstoff beigemischt, mit dem Ziel, diesem bestimmte Eigenschaften zu verleihen.

Die meist in hohen prozentualen Anteilen verwendeten Füllstoffe haben häufig eine signifikante Erhöhung des Elastizitäts-Moduls (E-Modul) zur Folge. Diese ist aber meist mit geringeren Reißdehnungs- und Impact-Werten verbunden. Für die umfassende Wirkung des Effektes, der im Weiteren beschrieben wird, spielen die Füllstoffe und auch die Additive jedoch nur eine untergeordnete Rolle, was im Weiteren noch erläutert werden wird. Es wird ferner gezeigt, dass sich die im Weiteren beschriebene Methode somit für alle, das heißt reine thermoplastische oder gefüllte bzw. mit Additiven versehene Kunststoffe, anwenden lässt.

Die Effekte, die sich auf das thermoplastische Verhalten der verwendeten Kunststoffe begründen, spielen sich im Interface ab, also in dem Grenzbereich, in dem aufzubringendes Material und Polymermaterial zusammentreffen bzw. sich Bestandteile sowohl des einen als auch des anderen Materials befinden. Erfindungsgemäß wird dieser Effekt ausgenutzt, indem auf eine nicht oder schwach vorbehandelte, also nur gering vorstrukturierte Oberfläche des thermoplastischen Polymermaterials mit speziellen Beschichtungsverfahren nur wenige Monolagen des aufzubringenden Materials deponiert werden.

Diese geringe Vorstrukturierung dient nur dem Zweck der Erhöhung der Oberflächenenergie. Diese Erhöhung wird unter bestimmten Umständen erforderlich, weil für den Fall der Beschichtung von nur wenigen Monolagen des aufzubringenden Materials nur solche thermoplastischen Polymere als Substrat verwendet werden können, die einen entsprechenden Kondensationskoeffizienten für das aufzubringende Material besitzen. Der Kondensationskoeffizient ist der Quotient aus der Masse des tatsächlich auf der Polymeroberfläche adsorbierten und der Masse des auf die Polymeroberfläche einfallenden Materials und sollte daher aufgrund herstellungstechnischer Effizienzgründe mindestens größer als 0,5 sein. Diese Vorstrukturierung lässt sich, wie bereits beschrieben, durch verschiedene vakuumtechnische Oberflächenbearbeitungsmethoden, zum Beispiel plasmaphysikalische, plasmachemische bzw. ionentechnische Bearbeitung, chemische Oberflächenbearbeitungsmethoden, zum Beispiel Ätzen bzw. Anätzen, elektrochemische Oberflächenbearbeitungsmethoden, zum Beispiel elektrochemisches Ätzen, oder andere Oberflächenbearbeitungsmethoden, realisieren. Sie muss jedoch nur mit einer Intensität durchgeführt werden, die zu einer Morphologie führt, mit der die Anforderungen an den Kondensationskoeffizienten bei einer Beschichtung mit einem aufzubringenden Material erfüllt werden können. Die sich aus diesem Grund herausbildende Oberflächenstruktur entspricht deshalb auch annähernd nicht der Oberflächentopographie, die durch die bereits beschriebene lonenspurtechnologie oder durch die Oberflächenbearbeitung mit energetischen Schwerionen, insbesondere bei Fluorpolymeren, bei der Herausbildung von Strukturelementen erzielt wird. Die einzige Anforderung an diese geringe Oberflächenstrukturierung besteht darin, dass während eines Beschichtungsprozesses mit einem anderen Material ein entsprechender Kondensationskoeffizient realisiert werden kann.

In **Figur 6** sind Rasterelektronenmikroskopaufnahmen (REM-Aufnahmen) verschiedener Polymeroberflächenmodifikationen verschiedener Materialien, als Beispiele für nicht beziehungsweise gering vorstrukturierte Oberflächen, abgebildet.

Die **Figur 6** zeigt in
**a)** eine unbehandelte PEEK-Folie; Vectran (PEEK);
**b)** eine sehr schwach angeätzte Polycarbonatfolie; Bayfol;
**c)** eine stärker angeätzte Polycarbonatfolie; Polycarbonat und in
**d)** eine angeätzte Kunststofffolie (Quelle: BASF, Ludwigshafen).

Ein Kondensationskoeffizient ist folglich für jede spezielle Kombination thermoplastisches Polymer/aufzubringendes Material verschieden und hängt von der spezifischen Oberflächenenergie des Polymermaterials für das entsprechend aufzubringende Material ab. Ist dieser Koeffizient zu klein, also kleiner als 0,5, dann ist es sinnvoll, eine entsprechende geringe Vorstrukturierung der Oberfläche vorzunehmen. Der Kondensationskoeffizient folgt darüber hinaus der Reaktivität des aufzubringenden Materials. Unter Reaktivität ist in diesem Zusammenhang das Vermögen des Materials zu verstehen, an die Polymeroberfläche anhaften bzw. andocken zu können. Dieser Trend ist an ermittelten Werten an Kupfer (Cu), Silber (Ag) und Gold (Au) zu erkennen. So liegt der Kondensationskoeffizient bei PMMA für Cu am höchsten, der von Ag und Au hingegen am niedrigsten **[**J. Faupel, Dissertation: "Wachstum von metallischen Nanoclustern auf Polymeroberflächen", Göttingen, 2005] (Seite 42 - 47).

Atome, die zum Beispiel bei einem Vakuumbeschichtungsprozess auf die Polymeroberfläche auftreffen, führen auf dieser einen Random-Walk durch, das heißt die Diffusion des aufgebrachten Materials auf der Polymeroberfläche wird als Braun'sche Bewegung angenommen **[**Thran, A.; Kiene, M. ; Zaporojtchenko, V.; Faupel, F.: Condensation Coeffcients of Ag on Polymers. In: Phys. Rev. Lett. 82 (1999), S. 1903**].** Die Wechselwirkungen von Teilchen mit der Oberfläche werden dabei hauptsächlich von der kinetischen Energie der Teilchen bestimmt. Dieser Random-Walk, der beim Auftreffen der Teilchen hervorgerufen wird, bedeutet bei niedriger Substrattemperatur niedrige Oberflächenbeweglichkeit, das heißt es bilden sich inselförmig wachsende Körner heraus, die bevorzugt in Richtung des auftreffenden Partikelstroms wachsen. Diese Schichten besitzen eine hohe Porosität, geringe Dichte und große Rauigkeit. Eine gering vorstrukturierte Oberfläche begrenzt gewissermaßen die dem Random-Walk frei zur Verfügung stehende Fläche und begünstigt demzufolge die Körnerbildung.

Derartige Schichten lassen sich mit konventionellen Techniken im Vakuum (Verdampfen, Zerstäuben) erzeugen. Auch die Erhöhung des Arbeitsdruckes während des Beschichtungsprozesses führt zu einem vergleichbaren Ergebnis. Adatome, also die Atome (Fremdatome oder Atome des aufzubringenden Materials), die an die Festkörperoberfläche gebunden werden sollen, geben durch Kollisionen einen Teil ihrer kinetischen Energie aus dem Beschichtungsprozess an das umgebende Gas ab. Dadurch fehlt ihnen Energie für eine Oberflächenmigration bzw. -diffusion, weshalb dieses Verhalten mit dem bei niedriger Oberflächentemperatur vergleichbar ist. Die entstehende Schichtstruktur ist somit für niedrige Substrattemperaturen und hohe Drücke charakteristisch. Die auftreffenden Atome haben eine geringe Beweglichkeit auf der Oberfläche. Die während des Beschichtungsprozesses entstehende Struktur kann in ihrem Ansatz sowohl amorph als auch polykristallin sein. Die entstehende Schicht besteht aus sich verjüngenden kristallitähnlichen Körnern, die eine poröse Schicht mit eingebauten Hohlräumen bilden. Diese Körner, die in der Fachliteratur als Cluster bezeichnet werden, weisen eine hohe Fehlordnungsdichte auf. Die entstehende Clusterstruktur ist quasi auf der Oberfläche "eingefroren" und weist eine Schichtdicke im nanoskaligen Bereich auf. Diese Cluster an sich stellen bereits sogenannte Nukleationskeime dar, also Keime, die die Basis für eine sich anschließende Keimbildung darstellen können. Aus diesem Grund müssen die Beschichtungsbedingungen dahingehend eingestellt werden, dass der Keimbildungsprozess (Nukleationsprozess) nicht beginnen kann oder nur zufällige Nukleationen von zwei sich treffenden Adatomen (random nucleation) oder die Nukleation an bevorzugten Plätzen auf der Oberfläche (preferred nucleation) auftreten können.

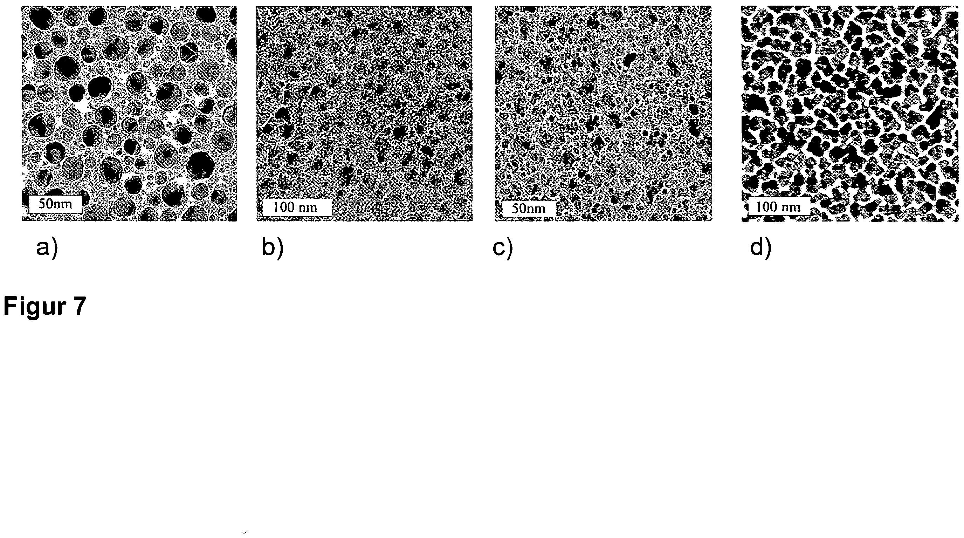

In der Regel weisen solche Cluster eine radiale Ausdehnung zwischen 5 nm und weniger als 100 nm auf. Dabei liegt die sich ausbildende Schichthöhe im Bereich zwischen 10 nm und 50 nm. Aus diesem Grund wird diese Struktur als nanoskalige Schicht bezeichnet. Die quasi beste der in **Tabelle 1** aufgeführten Methoden, derartige Oberflächenstrukturen darzustellen, ist die Transmissionelektronenmikroskopaufnahme (TEM-Aufnahme). In **Figur 7** sind verschiedene Transmissionelektronenmikroskopaufnahmen (TEM)-Aufnahmen verschiedener Metallcluster auf verschiedenen Polymeren abgebildet. Die Äquivalentschichtdicken (ÄSD) der Cluster sind in Monolagen (ML) angegeben.

Dabei zeigt die **Figur 7** in
**a)** Silber(Ag)-Cluster auf Polycarbonat (PC), mit einer ÄSD von 19,7 ML;
**b)** Kupfer(Cu)-Cluster auf Polycarbonat (PC), mit einer ÄSD von 16,2 ML;
**c)** Palladium(Pd)-Cluster auf Polycarbonat (PC), mit einer ÄSD von 13,8 ML;
**d)** Palladium(Pd)-Cluster auf Polymethylmethacrylat (PMMA), mit einer ÄSD von 34,4 ML.
(Quelle: J. Faupel "Wachstum von metallischen Nanoclustern auf Polymeroberflächen", Georg-August-Universität zu Göttingen, 2005) (a) Seite 52, b) Seite 91, c) Seite 96, d) Seite 98)).

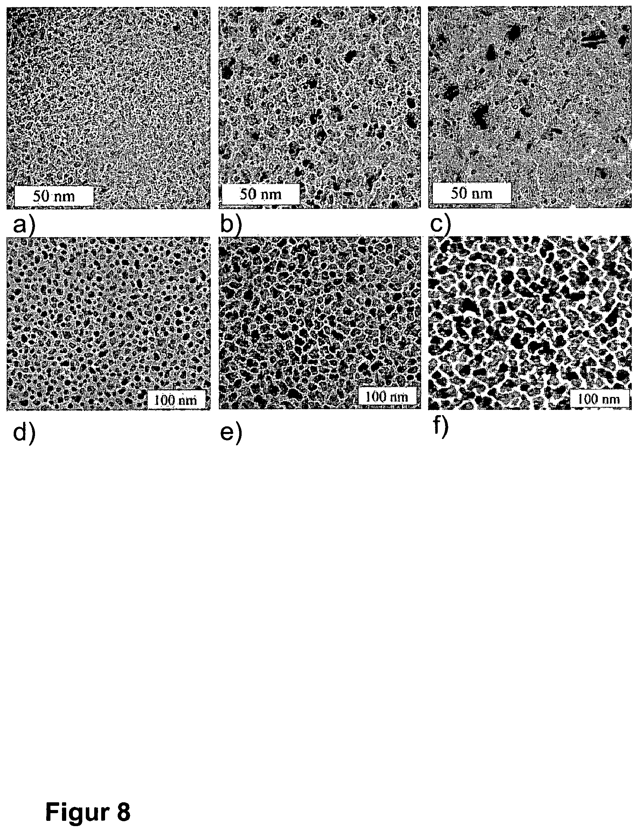

In **Figur 8** sind Transmissionelektronenmikroskopaufnahmen (TEM-Aufnahmen) von Palladium (Pd) auf Polycarbonat (PC) und auf Polymethylmethacrylat (PMMA) dargestellt (Quelle: J. Faupel "Wachstum von metallischen Nanoclustern auf Polymeroberflächen", Georg-August-Universität zu Göttingen, 2005) (a), b), c) Seite 96, d), e), f) Seite 98). Dabei sind in der **Figur 8** die TEM-Aufnahmen **a)** bis **c)** von Palladium auf Polycarbonat (PC) und die TEM-Aufnamen **d)** bis **f)** von Palladium auf Polymethylmethacrylat (PMMA; Plexiglas) abgebildet. Die Äquivalentschichtdicken (ÄSD) der Cluster sind in Monolagen (ML) angegeben. Es wurden folgende Äquivalentschichtdicken an Pd auf die PC-Oberfläche deponiert: **a)** 6,9 ML, **b)** 13,8 ML, **c)** 27,6 ML. Des Weiteren wurden folgende Äquivalentschichtdicken an Pd auf die PMMA-Oberfläche deponiert: **d)** 8,6 ML, **e)** 17,2 ML, **f)** 34,4 ML. Die Cluster in Bild **e)** und **f)** agglomerieren zu größeren Inseln, ohne jedoch zu koaleszieren. Im Vergleich zwischen PC und PMMA wird die PMMA-Matrix wesentlich schwächer benetzt, und es bildet sich keine mäanderförmig perkolierende Schicht aus.

In den in der **Figur 8** abgebildeten TEM-Aufnahmen **a)** bis **c)** des Wachstums von Pd auf PC offenbart sich ein völlig anderes Bild als zum Beispiel bei Silber (Ag) auf PC, wie in der **Figur 7** in der Aufnahme **a)** gezeigt. In den Frühstadien des Wachstums ist die Bildung von Pd-Clustern zu beobachten, ähnlich stark facettiert wie bei dem Wachstum von Cu auf PC, wie in der **Figur 7** in Bild **b)** gezeigt. Im weiteren Verlauf des Wachstums bildet sich offensichtlich ein gemischtes Lagen- und Inselwachstum aus. Es sind zu jedem Zeitpunkt Pd-Cluster auf der Polymeroberfläche zu finden, jedoch bildet sich gleichzeitig eine mäanderförmig perkolierende Struktur aus. Ein Cluster ist dann perkolierend, wenn gegenüberliegende Ränder des eingebetteten Raumes bzw. Gitters verbunden sind. Zwischen den einzelnen Clustern gibt es auch in diesem Fall, und diese Tatsache ist wiederum wichtig für die erfindungsgemäße Anwendung des beschriebenen Effektes, hinreichend große Freiräume, das heißt freie Volumina.

Kleine Körnchen wie Cluster besitzen unter anderem auch, selbstverständlich innerhalb energetischer und oberflächenenergetischer Grenzen, eine Mobilität. Aus diesem Grund kann bei Erhöhung der abgeschiedenen Partikel des aufzutragenden Materials der Fall eintreten, dass kleine Cluster zu größeren agglomerieren können, das heißt, dass sich die bereits gebildeten kleinen Körner vergrößern, indem kleinere Cluster zu größeren zusammenwachsen, wie in **Figur 8** in **e)** und **f)** zu sehen. Mit dem Begriff Agglomerieren wird also eine Kornvergrößerung beschrieben. Dieser Prozess unterscheidet sich jedoch wesentlich von dem Koaleszenzprozess. Zwischen den einzelnen "größeren" Clustern gibt es auch im Fall des Agglomerierens, und diese Tatsache ist abermals wichtig für die erfindungsgemäße Anwendung des beschriebenen Effektes, hinreichend große Freiräume, das heißt freie Volumina, wie in **Figur 8** in **f)** zu sehen.

Es können sich demnach durch Anwendung spezieller Beschichtungsbedingungen im Vakuum, zum Beispiel durch einen prozessual fraktionierten Materialauftrag, weitere Atome an vorhandene Cluster anlagern, wobei auf der Grundlage des Effektes des Agglomerierens auch die Möglichkeit besteht, dass sich weitere Cluster anlagern können. In diesem Zusammenhang wird von einem Clusterwachstum gesprochen. Auch in diesem Fall sind die Bedingungen in der Form einzustellen, dass der Wachstumsprozess bereits zu einem Zeitpunkt abgebrochen, also "eingefroren", wird, bevor Koaleszenzerscheinungen, also das Zusammenfließen der Cluster durch Zusammentreffen und Verschmelzen, wobei dadurch die Oberfläche des entstehenden "Tröpfchens" (Kristallites) kleiner als die Summe der einzelnen wird, stattfinden und dadurch beginnen, die Oberfläche des Polymers vollständig zu bedecken. Die Cluster sollen sich für die erfindungsgemäße Anwendung immer in der Form zusammenfügen, dass eine Zusammensetzung entsteht, die als fraktales oder zweidimensionales Wachstum bezeichnet wird oder einer perkolierenden Clusterstruktur oder agglomerierten Körnern entspricht, zwischen denen immer noch hinreichend großer Freiraum bzw. freies Volumen vorhanden ist.

Zusammenfassend lässt sich die entstehende Struktur des aufzubringenden Materials folgendermaßen charakterisieren:
Für die erfindungsgemäße Anwendung soll sich eine Schicht des aufzubringenden Materials herausbilden, die sich als Cluster mit einer porösen, perkolierenden oder fraktalen Strukturform oder als agglomerierte Cluster mit einer nanoskaligen Schichtdickenausdehnung auffassen lässt, die die Oberfläche des thermoplastischen Polymers nur partiell bedeckt, was bedeutet, dass zwischen den einzelnen Agenzien ein für die erfindungsgemäße Anwendung hinreichend großer Freiraum vorhanden ist.

Erfindungsgemäß wird diese durch verschiedene Verfahren herstellbare und auf das thermoplastische Polymer aufgebrachte Schicht weiterverarbeitet, indem diese Schicht in einem vorgegebenen Zeitintervall, d.h. impulsartig mit einer Impulsdauer im Bereich von 1 ms bis 100 s, durch Wärmezufuhr beeinflusst wird, wobei die Temperatur der Wärmequelle bis zu 500 K oberhalb der Schmelztemperatur des Polymermaterials liegt, oder simultan Wärme in der genannten Form zugeführt und ein Druck, also eine Kraft pro Fläche, der im Bereich zwischen 10 % und 150 % der Zugfestigkeit des Polymermaterials liegt, auf diese Schicht ausgeübt wird. Dabei sind entweder nur die Wärme oder die Wärme und der Druck dergestalt zu dimensionieren, dass durch den Wärmeübertrag auf den Oberflächenbereich des aufgebrachten Materials und des Thermoplasten die Formänderungsfähigkeit nur in einem Zonenbereich nahe der Oberfläche des Polymers stattfindet, bis das Material beginnt zu fließen, also die Fließtemperatur T_{f} beziehungsweise die Kristallitschmelztemperatur Tₘ überschritten wird, das heißt sich der Übergang vom Glaszustand in den flüssigen Zustand vollzieht. Ist das aufzubringende Material zum Beispiel ein Metall, dann wird die Wärme aufgrund der besseren Wärmeleitfähigkeit bezogen auf das Polymermaterial direkt in der unmittelbaren Umgebung der aufgebrachten Cluster (zum Beispiel Metallcluster) in das Polymermaterial übertragen. Dieser direkte Kontakt führt dazu, dass diese Zonen des Polymermaterials als erste Bestandteile zu fließen beginnen. Bei simultaner Druckausübung wirken durch den Druck, der auf diese Cluster ausgeübt wird, diese wie kleinste Stempel, sogenannte Nanostempel, die aufgrund des Aufschmelzens der Umgebung in das Polymermaterial hineingedrückt werden. Das durch die Wärmezufuhr und den wirkenden Druck verursachte Fließverhalten des Polymers bewirkt, dass die Schmelze, also das flüssige Polymermaterial, in die vorhandenen Freiräume, auch in die Freiräume in den Clustern, hineinfließt und um die lokalen Schichtstrukturen (Cluster) herumfließt.

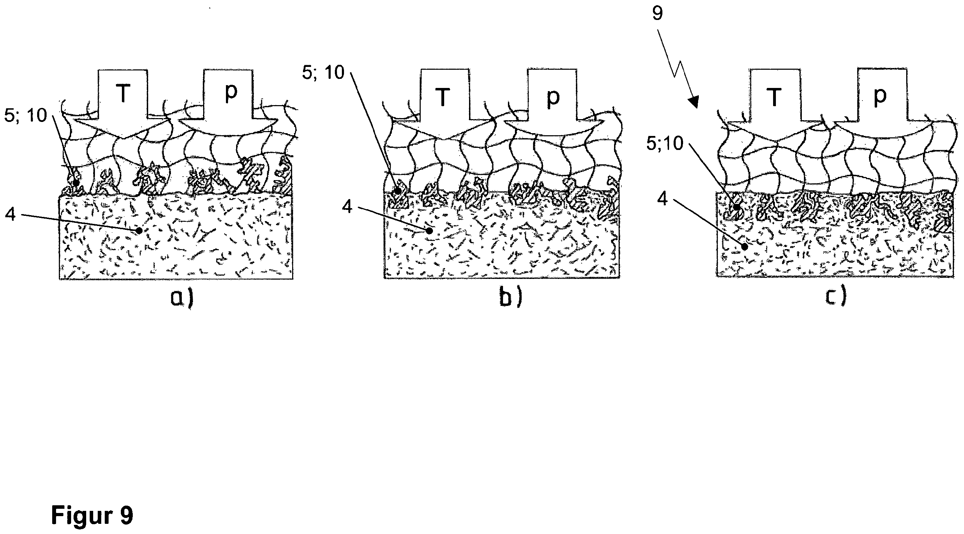

Die **Figuren 9a** bis **9c** zeigen eine schematische Schnittdarstellung der Beeinflussung der mit einem aufzubringenden Material 5 beschichteten Polymeroberfläche des thermoplastischen Trägermaterials 4, die unbehandelt oder gering vorbehandelt beziehungsweise strukturiert (vgl. **Figuren 4a** bis **c)** ist, durch eine Wärme (T)- bzw. eine simultane Wärme (T)- und Druckbehandlung (p). Die Zeitdauer der Einwirkung ist so dimensioniert, dass sich der zu erzielende Effekt vollständig, wie in **Figur 9c** gezeigt, einstellen kann.

Die **Figur 9a** zeigt in den Ausgangszustand zu Beginn der Behandlung. Die **Figur 9b** zeigt den Zustand, in dem der oberflächennahe Bereich des thermoplastischen Trägermaterials 4 zu fließen beginnt und die Cluster 10 aus aufgebrachtem Material 5 in das Trägermaterial 4 eindringen. Die **Figur 9c** zeigt den Zustand, in dem die Cluster 10 vollständig in das thermoplastische Trägermaterial 4 eingedrungen sind, die Freiräume 6 zwischen den Clustern 10 und innerhalb der Cluster 10 aufgefüllt sind und die aufgebrachte Schicht 5 in das thermoplastische Polymer 4 eingebettet ist.

Auch in diesem Fall erweist es sich als vorteilhaft, dass mit steigender Temperaturerhöhung eine Abnahme der Viskosität des Polymermaterials 4 verbunden ist, was bewirkt, dass die Kunststoffschmelze leichter fließt und somit in kleinste Hohlräume eindringen kann. Insbesondere durch den anliegenden Druck werden Gasteilchen, die sich in kleinsten Frei- beziehungsweise Hohlräumen und Poren befinden und dort gefangen sind, von dem geschmolzenen Polymermaterial verdrängt. Problemlos kann der Prozess gewissermaßen soweit getrieben beziehungsweise fortgesetzt werden, dass die aus Clustern 10 aufgebaute Schicht des aufzubringenden Materials 5 vollständig beziehungsweise nahezu vollständig in das Polymermaterial 4 eingebettet ist.

Anhand dieser Beschreibung wird nunmehr auch deutlich, warum die Füllstoffe und in gewisser Weise auch die Additive nur eine untergeordnete Rolle spielen. Die beschriebene Methode verdeutlicht, dass sich die für die Verbundbildung, das heißt für die Ausbildung eines Komposits 9, verantwortlichen Prozesse im Interface-Bereich abspielen und auf das thermoplastische Verhalten der Polymerkomponente 4 zurückzuführen sind.

Vorteilhaft lässt sich, wenn das aufzubringende Material einer leitfähigen Substanz entspricht, sowohl in der ersten als auch der zweiten beschriebenen Methode zur Erzeugung haftfester Verbunde zwischen thermoplastischen Materialien 4 und einem aufzubringenden Material 5 die Wärmezufuhr durch ein spezielles Verfahren realisieren, nämlich, indem die Energiezufuhr für die Erwärmung des oberflächennahen Bereiches des Polymers 4 nur direkt über die leitfähigen Komponenten des aufgebrachten Materials 5 vorgenommen wird.

Eine solche Erwärmung erfolgt erfindungsgemäß mittels Mikrowellenstrahlung. Mikrowellen sind elektromagnetische Wellen. Sie können daher von dem Material, mit dem sie interagieren, reflektiert, durchgelassen oder absorbiert werden. Mikrowellen liegen in dem gleichen Frequenzband wie die allgemein bekannten Radarwellen, das heißt sie sind kurzwelliger als die Radio- und Fernsehwellen, aber wesentlich langwelliger als das sichtbare Licht. Ihre Wirkung auf Materie ist rein thermischer Art, es findet also im Gegensatz zu den kurzwelligen Strahlen, wie Röntgen- oder Gammastrahlen, keinerlei ionisierende Wirkung statt. Um Materialien mittels Mikrowellen erwärmen zu können, müssen diese an die Mikrowelle ankoppeln, das heißt, sie müssen elektromagnetische Energie absorbieren.

Thermoplaste, wie zum Beispiel Fluoropolymere, PEEK oder Polypropylen und viele andere mehr, sind mikrowellentransparente Materialien, die nicht von Mikrowellen erwärmt werden, sie erfahren somit keine direkte Beeinflussung durch diese Strahlung. Andererseits gehören quasi alle Metalle, zum Beispiel Silber oder Kupfer, in die Gruppe der mikrowellenreflektierenden Materialien, die somit ebenfalls eigentlich nicht durch Mikrowellenstrahlung erwärmt werden können. Viele andere Materialien, zum Beispiel auch Wasser, fallen aufgrund der Besonderheit des Molekülaufbaus (das Wasser ist mit einem Dipolmoment behaftet) in die Kategorie der mikrowellenabsorbierenden Materialien und können daher durch diese Strahlung erwärmt werden. Die Ursache dafür ist darin zu sehen, dass die Moleküle versuchen, sich in dem schnell wechselnden elektrischen Feld, das durch die Wechselwirkung mit der Mikrowelle hervorgerufen wird, stets in Richtung der Feldlinien auszurichten und so in Rotationsschwingungen versetzt werden. Obwohl Metalle prinzipiell Mikrowellen reflektieren, muss deutlich gemacht werden, dass die Mikrowellenstrahlung bei Metallen durch delokalisierte Metallelektronen einige Mikrometer tief in das Material eindringt und dadurch Schwingungen dieser Elektronen erzeugt. Dadurch entstehen im Material Wärmeverluste (Dissipation). Sind also die Metallschichten sehr dünn, dann entstehen in diesen Schichten hohe Spannungen und es fließen Ströme. Dadurch können die Metallschichten so heiß werden, dass sie sogar verdampfen können und sich Funkenüberschläge ausbilden. Erst bei hinreichend großen Metallschichtdicken wird die Strahlung reflektiert und die Restwärme abgeleitet.

In den im ersten und zweiten Fall beschriebenen Methoden handelt es sich bei dieser speziellen Anwendung, also beim Einsatz von Mikrowellen, jedes Mal für die erfindungsgemäßen Anwendungen um eine elektrisch leitfähige Schicht des aufzubringenden Materials, wobei im ersten Fall von einem thermoplastischen Material mit einer bereits vorstrukturierten Oberfläche ausgegangen wird, in die mit einem speziellen Beschichtungsverfahren wenige Monolagen des aufzubringenden elektrisch leitfähigen Materials in der Form eingebracht worden sind, dass die Atomlagen des leitfähigen Materials in Summe einen nanoskaligen Schichtdickenbereich umfassen und es sich im zweiten Fall um eine leitfähige Schicht handelt, die aus Clustern aufgebaut ist, also entweder aus einzelnen Clustern oder aus Clustern mit einer porösen, perkolierenden oder fraktalen Strukturform oder aus agglomerierten Clustern mit einer nanoskaligen Schichtdickenausdehnung, die die Oberfläche des thermoplastischen Polymers nur partiell bedeckt. In beiden Fällen handelt es sich somit, wie bereits erläutert, um eine äußerst dünne, aber bereits elektrisch leitfähige Schicht und somit um einen Schichtdickenbereich, in dem im gesamten Bereich der aufgebrachten Schicht, wie bereits erläutert, eine Wechselwirkung zwischen elektromagnetischer Welle und dem Metall und demzufolge eine Erwärmung auftritt. Der Widerstandsmesswert dieser Schichten ist wesentlich größer als bei Metallen, deren Schichtaufbau größer als einige µm beträgt. Die Oberflächenwiderstandswerte der aufgebrachten leitfähigen Atomlagen liegen dabei in der Größenordnung zwischen 500 Ω bis 50 Ω. Gerade dieser Widerstandsbereich bewirkt, dass diese Strukturen Mikrowellen außerordentlich absorbieren können und sich daher durch diese Strahlung erwärmen lassen, obwohl sie leitfähig sind. In diesem Bereich kommt die Wirkung der Mikrowellenstrahlung somit überaus effektiv zur Wirkung. Aufgrund der spezifischen Wirkung der Mikrowellenstrahlung hängt die Erwärmung von der vom Material absorbierten Leistung, der Mikrowellenfrequenz, der elektrischen Feldkonstante ε₀, dem Imaginärteil des komplexen Dielektrizitätskoeffizienten ε, der elektrischen Feldstärke E und vom Materialvolumen ab. Der Imaginärteil des komplexen Dielektrizitätskoeffizienten ε ist proportional zum Widerstand des die Mikrowellenstrahlung absorbierenden Materials, also dem Material, das wenige Atomlagen beträgt und das auf das thermoplastische Material aufgebracht worden und deshalb aufgrund des relativ hohen Widerstandswertes so effektiv wirksam ist.

Im Gegensatz zu bereits beschriebenen Erwärmungsmethoden spielt bei der Mikrowellenerwärmung das Material, also das aufgebrachte leitfähige Material, und seine Form eine wesentlich größere Rolle als bei anderen Methoden. Die Fähigkeit eines Stoffes, Mikrowellenenergie zu absorbieren, wird somit wie beschrieben durch seinen dielektrischen Verlustfaktor ausgedrückt, welcher stets mit der Dielektrizitätskonstanten verknüpft ist. Dieser dielektrische Verlustfaktor ist stoff-, frequenz- und temperaturabhängig. Er bestimmt damit, wie gut das Material von Mikrowellen erwärmt werden kann. Die Form bzw., noch genauer, das Volumen bestimmt, wie viel Mikrowellenenergie das System aufnehmen kann.

In dem erfindungsgemäßen Fall ist die Mikrowellenenergie so zu wählen, dass die vom Material absorbierte Wärmeleistung so groß wird, dass nur die Zonen des Polymermaterials, die unmittelbar mit dem aufgebrachten Material verbunden sind, eine Wärmeabgabe solchermaßen erfahren, dass sie beginnen zu fließen. Für eine mit mehreren Atomlagen metallisierte Polymerfolie lässt sich für die Bestrahlung mit einem 2,45 GHz-Magnetron angeben, dass die Bestrahlungsleistung im Bereich zwischen 1 Ws/cm² bis 10000 Ws/cm² bei einer Expositionszeit zwischen 0,1 s bis 150 s liegt. Zur Optimierung des Wärmeeintrages kann die Mikrowellenbestrahlungsleistung auch mittels Impulsfolgen zugeführt werden. Die Impulsbreiten liegen dabei im Bereich von 0,01 s bis zu mehreren Sekunden.

Ausgenutzt wird dabei die Tatsache, dass die Metallschichten eine verhältnismäßig kleine Masse und ein kleines Volumen darstellen, die sich bei Optimierung der Mikrowellenleistung und ihrer Einwirkungsdauer derart genau aufheizen lassen, dass der Wärmeübertrag auf das thermoplastische Material lediglich den benötigten Effekt des Aufschmelzens der angrenzenden Polymerschicht bewirkt. Es ist maximal 10 % der Wärmemenge für diesen beschriebenen Prozess notwendig, als für das Aufschmelzen des gesamten Folienbandes erforderlich wären. Der große Vorteil dieser Methode besteht genau darin, dass tatsächlich nur die Zonen an der Oberfläche und im oberflächennahen Bereich des thermoplastischen Polymermaterials in einem Zeitfenster, der Expositionszeit, in dem der betreffende Bereich mit Mikrowellenstrahlung wechselwirkt, um diese Wärmeleistung zu erzeugen, so erwärmt werden können, dass sich ein haftfester Verbund zwischen der aufgebrachten leitfähigen Schicht und dem Polymermaterial ausbildet. Diese Tatsache stellt einen außerordentlich großen Vorteil dar, weil in der Tat nur die für die Ausbildung des Haftverbundes notwendigen Bereiche extrem kurzzeitig betroffen sind und andere Festkörperregionen nahezu völlig unversehrt bleiben, weil sie den Übergang zur Schmelze überhaupt nicht vollziehen.

Es wird sowohl im Anschluss an die Prozesse der ersten als auch der zweiten beschriebenen Methode eine Oberflächenbearbeitung in der Form durchgeführt, dass die der Oberfläche am nächsten liegenden Bereiche des aufgebrachten Materials, wenn nötig, freigelegt, gereinigt und aktiviert werden. Dieser Bearbeitungsschritt lässt sich zum Beispiel durch Beschuss des Oberflächenbereiches mit linear beschleunigten energetischen Schwerionen realisieren. Die Ionen erfahren dabei je nach Bedingungen und Material eine Beschleunigungsspannung zwischen 1,5 und 10 keV. Dieser Bearbeitungsschritt lässt sich in einem Druckbereich von 1 × 10⁻⁴ bis 1 × 10⁻³ mbar in einer Vakuumkammer realisieren.

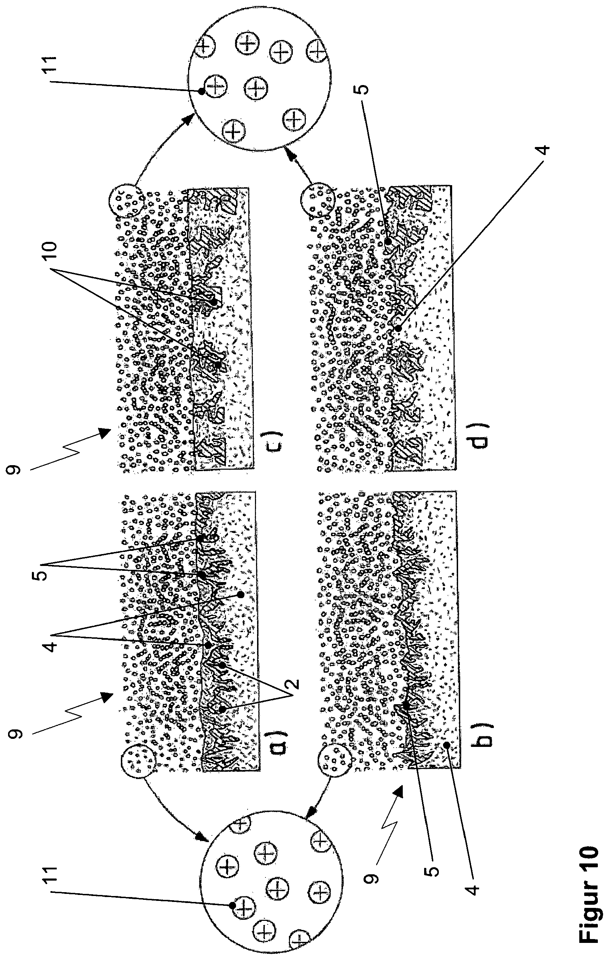

Mit Hilfe der gerichteten Ionen 11 werden die thermoplastischen Bestandteile abgetragen bzw. abgesputtert, wie in **Figur 10** gezeigt. Die **Figur 10** zeigt eine schematische Schnittdarstellung der Oberflächenbearbeitung des Komposits 9, bestehend aus thermoplastischen Komponenten des Trägermaterials 4 und der aufgebrachten Schicht 5, im unmittelbaren Oberflächenbereich mit energetischen Schwerionen 11. Dabei zeigt die **Figur 10** in **a)** den Beginn der Bearbeitung des Komposits 9, dessen Polymeroberfläche ursprünglich aus einer stochastischen Ansammlung von Strukturelementen 2 bestand, mit energetischen Schwerionen 11. In Abbildung **b)** der **Figur 10** ist zu sehen, dass ein Teil der aus thermoplastischen Komponenten des Trägermaterials 4 bestehenden Schicht durch die energetischen Schwerionen 11 abgetragen (abgesputtert) worden ist, wodurch Komponenten der aufgebrachten Schicht 5 freigelegt worden sind. In Abbildung **c)** der **Figur 10** ist der Beginn der Bearbeitung des Komposits 9, auf dessen ursprüngliche Polymeroberfläche eine nanoskalige Clusterschicht 10 abgeschieden worden ist, mit energetischen Ionen 11 schematisch dargestellt. In **Figur 10**, Abbildung **d),** ist gezeigt, wie ein Teil der aus thermoplastischen Komponenten des Trägermaterials 4 bestehenden Schicht durch die energetischen Schwerionen 11 abgetragen bzw. abgesputtert worden ist, wodurch Komponenten der aufgebrachten Schicht 5 freigelegt worden sind.

Ist das auf das thermoplastische Trägermaterial 4 aufgebrachte Material 5 ein Metall, zum Beispiel Kupfer, Aluminium, Nickel, Molybdän, Gold, Silber usw. oder ein Halbleiter, zum Beispiel Silizium oder ein keramischer Isolator, wie zum Beispiel Aluminiumoxid, dann ist es technologisch relativ einfach, die thermoplastische Polymerkomponente 4, die sich auf der Oberfläche befindet und das aufgebrachte Material 5 überdeckt, abzutragen, da die durch die auftreffenden Ionen 11 hervorgerufene Abtragrate (Absputterrate) für das thermoplastische Material 4 wesentlich höher ist als die des aufgebrachten Materials 5.

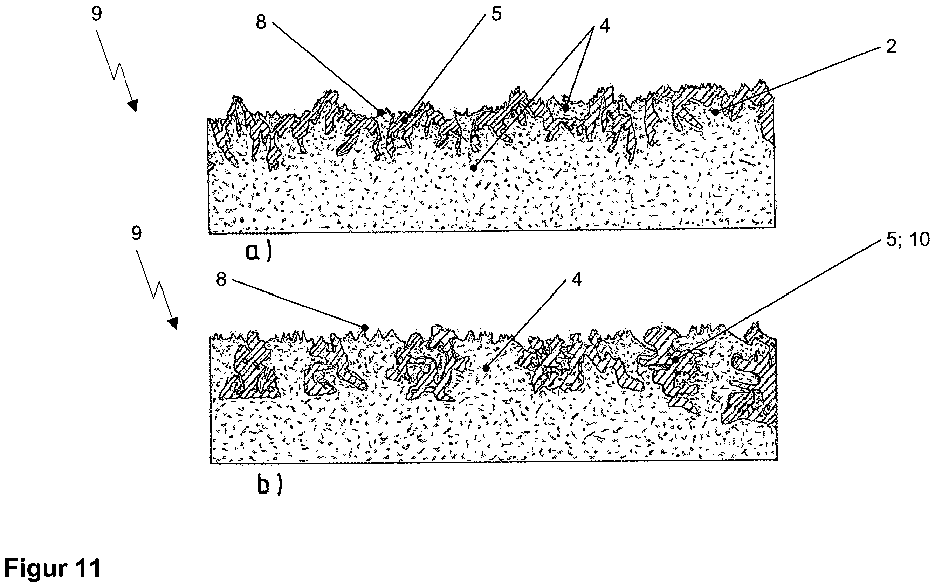

Die **Figuren 11a** und **11b** zeigen eine schematische Schnittdarstellung der Oberfläche 8 des Komposits 9 nach der Bearbeitung mit energetischen Schwerionen 11. Dabei zeigt **Figur 11a** ein Komposit 9, dessen Polymeroberfläche ursprünglich aus einer stochastischen Ansammlung von Strukturelementen 2 bestand, und **Figur 11b** ein Komposit 9, auf dessen ursprüngliche Polymeroberfläche eine nanoskalige Clusterschicht 10 abgeschieden worden ist. Stellt ein genügend großer Anteil an gereinigtem und aktivierten Material, das, wie beschrieben, in einen vorangegangenen Bearbeitungsschritt aufgebracht worden ist, einen entsprechend großen Oberflächenanteil, bezogen auf die gesamte Oberfläche, dar, wie schematisch in den **Figuren 11a** und **11b** dargestellt, dann wird eine weitere Beschichtung des aufzubringenden Materials 5 durchgeführt, bis die Oberfläche vollständig mit dem aufzubringenden Material 5 überzogen ist. Dieser Beschichtungsprozess lässt sich wiederum mit den bereits beschriebenen vakuumtechnischen oder nasschemischen oder anderen Verfahren realisieren.

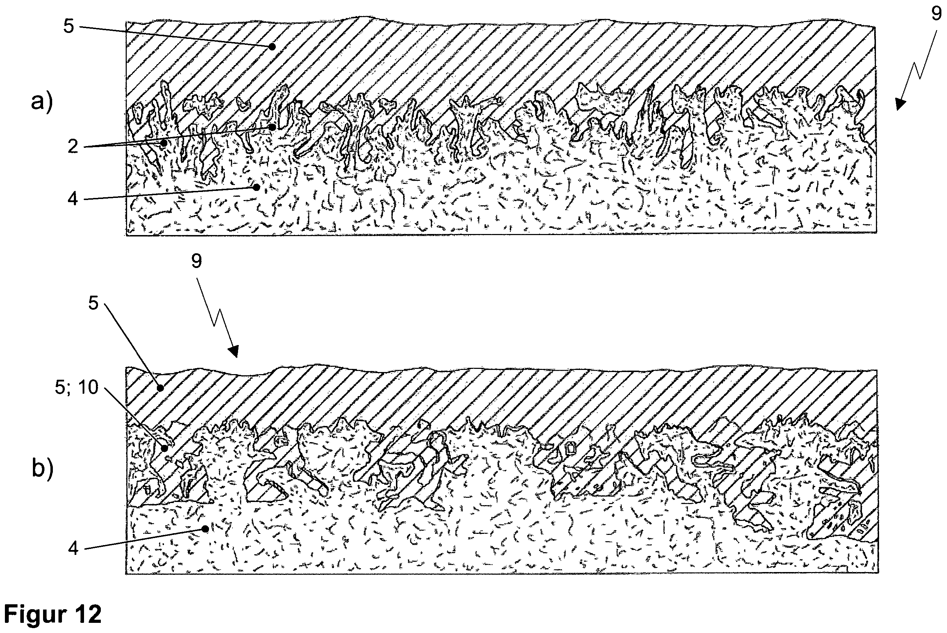

Die **Figuren 12a** und **12b** zeigen schematische Schnittdarstellungen der Schichtverstärkung des aufgebrachten Materials 5, nachdem die Komponenten des aufgebrachten Materials 5 partiell durch einen Bearbeitungsprozess mit energetischen Schwerionen freigelegt worden sind. Die **Figur 12a** zeigt ein Komposit 9, dessen Polymeroberfläche ursprünglich aus einer stochastischen Ansammlung von Strukturelementen 2 bestand, wohingegen die **Figur 12b** ein Komposit 9 zeigt, auf dessen ursprüngliche Polymeroberfläche eine nanoskalige Clusterschicht 10 abgeschieden worden ist. Den **Figuren 12a** und **12b** kann entnommen werden, dass die im ersten Bearbeitungsschritt aufgebrachten nanoskaligen Schichten des aufzubringenden Materials 5 nun wie Anker in dem thermoplastischen Polymermaterial 4 wirken, die im Fall der stark vorstrukturierten Oberfläche, siehe **Figur 12a****,** eine minimale Strukturtiefe von 80 bis 100 nm und im Fall der geringvorstrukturierten bzw. unbehandelten Oberfläche, siehe **Figur 12b****,** 20 bis 30

nm erreichen können.

Es wird ein haftfester Verbund zwischen einem thermoplastischen Substratmaterial mit einem anderen Material hergestellt, indem ein bereits in einem vorhergehenden Bearbeitungsprozess vorstrukturiertes oder ein zur Vergrößerung der Oberflächenenergie der damit verbundenen Erhöhung der Absorptionsfähigkeit für das aufzubringende Material schwach vorstrukturiertes oder gar unbehandeltes thermoplastisches Substratmaterial in einem ersten Arbeitsgang dergestalt beschichtet wird, dass sich eine erste aufgebrachte Schicht des anderen Materials mit einer nanoskaligen Schichtdicke ausbildet, das heißt mit einer Schichtdicke unter 100 nm, vorzugsweise zwischen 5 und 50 nm. Diese Schicht ist entweder entsprechend gut der Morphologie der stark vorstrukturierten Oberfläche angepasst oder auf einer schwach vorstrukturierten oder unbehandelten Oberfläche des thermoplastischen Substratmaterials in Form von einzelnen Clustern bzw. in Form von Clustern mit einer porösen, perklorierten oder fraktalen Strukturform bzw. in Form von agglomerierten Clustern des aufgebrachten Materials mit hinreichend großem Freiraum, das heißt freien Volumina, abgeschieden.

Für eine derartige Beschichtung lassen sich vorteilhaft verschiedene vakuumtechnische Methoden, wie zum Beispiel PVD-Verfahren oder CVD-Verfahren, verwenden. Zu den bevorzugten PVD-Verfahren zählen die Kathodenzerstäubung, dabei besonders bevorzugt das Magnetronsputtern, oder die Atomlagenabscheidung (ALD = Atomic Layer Deposition). Zu den bevorzugten CVD-Verfahren zählen Epitxie-Methoden, wie zum Beispiel die chemische Gasphasenepitaxie oder Atomlagenepitaxie, oder die plasma-unterstützte chemische Gasphasenabscheidung. So lassen sich nasschemische Verfahren, wie zum Beispiel die nasschemische Bekeimung der vorstrukturierten Thermoplastoberfläche mit Palladium oder mit einem leitfähigen Polymer und einer sich anschließenden chemischen Metallschichtabscheidung, eine sogenannte stromlose chemische Metallisierung, die in einem frühen Stadium des Metallschichtaufbaus, meistens nach etwa ca. 20 nm bis 30 nm Schichtdicke eines lokalen und damit noch nicht flächendeckenden Schichtaufbaus, abgebrochen wird, und noch weitere Beschichtungsmethoden bzw. -technologien verwenden. Auch solche Methoden, wie sie in Chang et al. (Appl. Phys. Lett. 51 (2), 13 July 1987), das heißt durch die Anpassung der aufgetragenen Kupferschicht an die vorhandene durch "Pre-Sputtering" erzeugte Oberflächenmorphologie, oder in der bereits erwähnten Schrift DE 10 2004 011 567 A1 beschrieben sind, können problemlos angewendet werden. Insbesondere durch Anwendung der an sich aus der Patentschrift DE 10 2004 011 567 A1 bekannten nanostrukturierten Nanokomposite enthaltenden Übergangsschichten kann überraschenderweise ein außerordentlich ausgeprägter haftfester Verbund zwischen dem Thermoplasten und dem aufzubringenden Material erzeugt werden, der auch für das erfindungsgemäße Verfahren von großem Vorteil sein kann.

In einem zweiten Arbeitsgang wird das durch den ersten Arbeitsgang erzeugte Komposit, also das thermoplastische Substrat, das die bereits beschriebenen verschiedenen Oberflächenstrukturformen besitzen kann oder eine unbehandelte Oberfläche darstellt, mit dem auf der Grundlage der durch die bereits beschriebenen verschiedenen Beschichtungsmethoden aufgebrachten nanoskaligen anderen Material in einem vorgegebenen Zeitintervall, d.h. impulsartig mit einer Impulsdauer im Bereich von 1 ms bis 100 s, durch Wärmezufuhr beeinflusst, wobei die Temperatur der Wärmequelle bis zu 500 K oberhalb der Schmelztemperatur des Polymermaterials liegt, und auf diese Schicht ein Druck, also eine Kraft pro Fläche, der im Bereich zwischen 10 % und 150 % der Zugfestigkeit des Polymermaterials liegt, ausgeübt. Dabei wird der Betrag der einzubringenden Wärmemenge und der Druck dergestalt dimensioniert, dass vornehmlich in den Bereichen des Substratmaterials, die sich in unmittelbarem Kontakt zu den aufgebrachten nanoskaligen Schichten, bestehend aus dem anderen Material, befinden, die Formänderungsfähigkeit des thermoplastischen Polymers zunimmt, bis es beginnt zu fließen. Die nanoskaligen Schichtstrukturen des aufgebrachten Materials sinken in einer Variante in die und gemeinsam mit den bereits in einem vorhergehenden Bearbeitungsprozess erzeugten Strukturelementen in das Polymermaterial vollständig bzw. nahezu vollständig ein, wobei alle vorhandenen Freiräume durch das thermoplastische Polymermaterial aufgefüllt werden. In einer anderen Variante findet vornehmlich in den Bereichen des Substratmaterials, die sich in unmittelbarem Kontakt zu den einzelnen Clustern bzw. den Clustern mit einer porösen, perkolierenden oder fraktalen Strukturform bzw. den agglomerierten Clustern des aufgebrachten Materials befinden, die Formänderung nur in einem Zonenbereich nahe der Oberfläche des Polymers statt, wobei die Cluster auf eine zur Vergrößerung der Oberflächenenergie und der damit verbundenen Erhöhung der Adsorptionsfähigkeit für das aufzubringende Material schwach vorstrukturierte bzw. eine unbehandelte Oberfläche des thermoplastischen Substratmaterials aufgebracht worden sind. So beginnt das Material zu fließen, also die Fließtemperatur T_{f} bzw. die Kristallitschmelztemperatur Tₘ wird überschritten, wodurch sich der Übergang vom Glaszustand in den flüssigen Zustand vollzieht. Das dadurch verursachte Fließverhalten des Polymers bewirkt, dass die Schmelze, also das flüssige Polymermaterial, in die vorhandenen Freiräume, siehe **Figur 9****,** auch in die Freiräume innerhalb der Clusterstrukturen hineinfließt und um die lokalen Schichtstrukturen, die Cluster, herumfließt, was bedeutet, dass die Clusterstrukturen in das Polymermaterial einsinken bzw. hineingedrückt werden.

Die Wärmezufuhr kann zum Beispiel durch Wärmestrahlung erfolgen, indem zum Beispiel die mit einem anderen nanoskaligen Material beschichtete Oberfläche des thermoplastischen Substratmaterials in einem vorgegebenen Zeitintervall, d.h. impulsartig mit einer Impulsdauer im Bereich von 1 ms bis 100 s, durch Wärmezufuhr beeinflusst wird, wobei die Temperatur der Wärmequelle bis zu 500 K oberhalb der Schmelztemperatur des Polymermaterials liegen kann, wobei es nur zu einer Beeinflussung der oberflächennahen Festkörperbereiche, also der an die nanoskaligen Schichten angrenzenden polymeren Zonen, kommt. Die Temperatur und die spezifische Wärmeleistung der Strahlung müssen dem Prozess in der Form angepasst werden, dass die erwünschte Wirkung erzielt wird. Ist zusätzlich das aufgebrachte nanoskalige Material eine leitfähige Substanz, kann der Wärmeeintrag durch eine kurzzeitige Wechselwirkung mit Mikrowellen erfolgen, wobei die leitfähigen Bestandteile die applizierte Mikrowellenstrahlung in Form von Wärme aufnehmen und diese dann an die direkt angrenzende thermoplastische Polymerumgebung abgeben. Dazu muss spezifische Leistung des Mikrowellensenders dem Prozess so angepasst werden, dass die erwünschte Wirkung erzielt wird. Für eine mit mehreren Atomlagen metallisierte Polymerfolie lässt sich für die Bestrahlung mit einem 2,45 GHz-Magnetron angeben, dass die Bestrahlungsleistung im Bereich zwischen 1 Ws/cm² bis 10000 Ws/cm² bei einer Expositionszeit zwischen 0,1 s bis 150 s liegt. Zur Optimierung des Wärmeeintrages kann die Mikrowellenbestrahlungsleistung auch mittels Impulsfolgen zugeführt werden. Die Impulsbreiten liegen dabei im Bereich von 0,01 s bis zu mehreren Sekunden.

Eine Wärmezufuhr unter gleichzeitiger Wirkung eines Druckes lässt sich beispielsweise durch eine beheizbare Druckvorrichtung, zum Beispiel eine Stempelvorrichtung, realisieren, die wiederum, um nur die oberflächennahen Festkörperbereiche zu beeinflussen, in einem vorgegebenen Zeitintervall, d.h. impulsartig mit einer Impulsdauer im Bereich von 1 ms bis 100 s, wirkt, wobei die Temperatur der Druckvorrichtung, die bis zu 500 K oberhalb der Schmelztemperatur des Polymermaterials liegt, und der ausgeübte Druck, der im Bereich zwischen 10 % und 150 % der Zugfestigkeit des Polymermaterials liegt, dem Prozess so angepasst werden, dass die erwünschte Wirkung erzielt wird. Ist das thermoplastische Substratmaterial ein Folienband, lässt sich die Folie über eine beheizbare Walze ziehen, wobei sich die Druckwirkung durch den Folienbandzug einstellen lässt. Ist das aufgebrachte nanoskalige Material eine leitfähige Substanz, kann der Wärmeeintrag durch kurzzeitige Wechselwirkung mit Mikrowellen bei gleichzeitiger Wirkung einer Druckvorrichtung (Stempel) erfolgen, wobei die leitfähigen Bestandteile die applizierte Mikrowellenstrahlung in Form von Wärme aufnehmen und dann an die direkte thermoplastische Polymerumgebung abgeben. Für eine mit mehreren Atomlagen metallisierte Polymerfolie lässt sich für die Bestrahlung mit einem 2,45 GHz-Magnetron angeben, dass die Bestrahlungsleistung im Bereich zwischen 1 Ws/cm² bis 10000 Ws/cm² bei einer Expositionszeit zwischen 0,1 s bis 150 s liegt. Zur Optimierung des Wärmeeintrages kann die Mikrowellenbestrahlungsleistung auch mittels Impulsfolgen zugeführt werden. Die Impulsbreiten liegen dabei im Bereich von 0,01 s bis zu mehreren Sekunden. Die spezifische Wärmeleistung des Mikrowellensenders und der ausgeübte Druck müssen dem Prozess so angepasst werden, dass die erwünschte Wirkung erzielt wird. Ist das thermoplastische Substratmaterial ein Folienband, lässt sich die Folie über eine Walze bei gleichzeitiger Einwirkung der Mikrowellenstrahlung ziehen, wobei sich die Druckwirkung durch den Folienbandzug einstellen lässt. Alle diese Prozesse sollten möglichst im Vakuum, zumindest jedoch in einer Schutzgasatmosphäre, stattfinden, da die Reaktivität, insbesondere der nanoskaligen Schichten des aufgebrachten Materials, sehr groß ist.

Erfindungsgemäß wird in einem dritten Arbeitsgang das durch den zweiten Arbeitsgang erzeugte Komposit derart weiterbearbeitet, dass im Anschluss an alle im zweiten Arbeitsgang beschriebenen Prozesse eine Oberflächenbearbeitung in der Form durchgeführt wird, dass die der Oberfläche am nächsten liegenden Bereiche des aufgebrachten Materials freigelegt, also oberflächenseitig von Polymermaterial befreit, gereinigt und aktiviert werden. Dieser vakuumtechnische Bearbeitungsschritt lässt sich insbesondere durch den Beschuss des Oberflächenbereiches mit linear beschleunigten energetischen Ionen mit einer Beschleunigungsspannung zwischen 1,5 und 10 keV und lonenstromdichten zwischen 0,02 und 0,5 A/mm², aber auch durch andere vakuumtechnische Bearbeitungsmethoden realisieren. Der dabei verwendete Arbeitsdruck liegt zwischen 1 × 10⁻⁴ und 1 × 10⁻³ mbar. Die energetischen Ionen können zum Beispiel durch die Anwendung einer Kauffmannlonenquelle oder durch Hochfrequenz-Dioden Sputteranordnungen erzeugt werden.

Erfindungsgemäß wird in einem vierten Arbeitsgang oder in noch nachfolgenden Arbeitsgängen eine weitere Beschichtung des aufzubringenden Materials durchgeführt, bis die Oberfläche vollständig mit dem aufzubringenden Material überzogen ist. Für eine derartige Beschichtung lassen sich wiederum verschiedene vakuumtechnische Methoden, wie zum Beispiel PVD-Verfahren, unter anderem Kathodenzerstäubung (Magnetronsputtern), oder plasmaunterstützte chemische Gasphasenabscheidung oder aber auch nasschemische Verfahren, wie zum Beispiel chemische, eine sogenannte stromlose chemische Metallisierung, oder elektrochemische Metallschichtabscheidung anwenden.

Als außerordentlich prozessdienlich erweist sich die Tatsache, wenn die ersten drei Arbeitsgänge als Vakuumprozess in der Form durchgeführt werden, dass die Prozesse nacheinander ablaufen, ohne dass das zu bearbeitende Material mit atmosphärischen Gasen und Luftfeuchtigkeit unter Normaldruckverhältnissen in Berührung kommt. Dadurch wird verhindert, dass die häufig extrem chemisch aktiven nanoskaligen Schichten des aufgebrachten Materials mit der Umgebung reagieren können, was eine spürbare Verschlechterung der erzielbaren Eigenschaften, nämlich der Erzeugung eines haftfesten Verbundes zwischen thermoplastischem Polymermaterial und aufzubringender Schicht, bedeuten würde. Ist die Oberfläche vollständig von dem aufgebrachten Material überzogen oder weist sogar einen im Vergleich zu den nanoskaligen Schichten großen Schichtdickenbereich auf, verringert sich auch die chemische Reaktivität der aufgebrachten Schicht.

### LISTE DER BEZUGSZEICHEN

- 1: fädchenartiger Strukturtyp, Strukturelement
- 2: fraktaler Strukturtyp, Strukturelement
- 3: säulenartiger Strukturtyp, Strukturelement
- 4: thermoplastisches Material, Trägermaterial, Substratmaterial, Polymer, Polymermaterial, thermoplastischer Festkörper
- 5: aufzubringende Schicht, aufgebrachte Schicht, aufzubringendes Material, aufzubringendes Metall, Beschichtungsmaterial, Metallschicht, aufgebrachtes Material, anderes Material
- 6: Freiräume, Hohlräume, freie Volumina, nicht aufgefüllte Bereiche
- 7: freie Flächenzonen, freie Oberflächenbereiche, freie Oberfläche, nicht abgedeckte Bereiche
- 8: Oberfläche des Komposits, Gesamtoberfläche, gesamte Oberfläche, geschlossene Oberfläche, Oberfläche des Festkörpers, Festkörperoberfläche, beschichtete Oberfläche
- 9: Komposit
- 10: Cluster, Clusterstruktur
- 11: Ionen, Schwerionen

## Patentansprüche

1. Verfahren zur Herstellung eines haftfesten Verbundes eines Substratmaterials, bestehend aus einem thermoplastischen Polymer (4) mit einer unbehandelten oder einer zur Erzielung einer Vorstrukturierung behandelten Oberfläche, mit einem anderen Material (5), bei dem
a) eine erste aufgebrachte Schicht des anderen Materials (5) mit einer nanoskaligen Schichtdicke, das heißt mit einer Schichtdicke unter 100 nm, durch thermische Behandlung in das thermoplastische Polymer (4) vollständig oder nahezu vollständig eingebettet wird, wobei unter nahezu eine 85 bis 99 %ige Einbettung des Volumens der eingearbeiteten Komponenten zu verstehen ist und der Anteil der Oberfläche des eingebetteten Materials (5) an der Gesamtoberfläche (8) aber nicht mehr als 35 % beträgt, und im Anschluss daran
b) die Oberfläche des anderen Materials (5) durch Beschuss mit energetischen Schwerionen (11) freigelegt und aktiviert wird und wiederum im Anschluss daran
c) die gesamte Oberfläche (8) mit dem anderen Material (5) beschichtet wird, bis sich mindestens eine geschlossene Schicht des anderen Materials (5) ausbildet,
wobei in Verfahrensschritt a) der Oberflächenbereich des thermoplastischen Polymers (4) mit der in Form einer nanoskaligen Clusterstruktur (10), das heißt einer porösen, perkolierenden oder fraktalen Strukturform des Materials mit einer nanoskaligen Schichtdickenausdehnung, aufgebrachten Schicht des anderen Materials (5) in einem vorgegebenen Zeitintervall, das heißt impulsartig mit einer Impulsdauer im Bereich von 1 ms bis 100 s, durch Wärmezufuhr (T) beeinflusst wird, wobei die Temperatur der Wärmequelle bis zu 500 K oberhalb der Schmelztemperatur des Polymermaterials (4) liegt und
• die Wärmemenge dergestalt dimensioniert wird oder
• auf diese Schicht ein Druck (p), also eine Kraft pro Fläche, der im Bereich zwischen 10 % und 150 % der Zugfestigkeit des Polymermaterials liegt, ausgeübt wird, wobei der Betrag der einzubringenden Wärmemenge (T) und der Druck (p) dergestalt dimensioniert werden,
dass vornehmlich in den Bereichen des Substratmaterials, des Polymers (4), die sich in unmittelbarem Kontakt zu den aufgebrachten Clustern (10) befinden, die Formänderungsfähigkeit des thermoplastischen Polymers (4) zunimmt, bis es beginnt zu fließen und die Schichtstrukturen des aufgebrachten Materials (5) in das Polymermaterial (4) vollständig oder nahezu vollständig einsinken.

2. Verfahren zur Herstellung eines haftfesten Verbundes eines Substratmaterials, bestehend aus einem thermoplastischen Polymer (4) mit einer unbehandelten oder einer zur Erzielung einer Vorstrukturierung behandelten Oberfläche, mit einem anderen Material (5), bei dem
a) eine erste aufgebrachte Schicht des anderen Materials (5) mit einer nanoskaligen Schichtdicke, das heißt mit einer Schichtdicke unter 100 nm, durch thermische Behandlung in das thermoplastische Polymer (4) vollständig oder nahezu vollständig eingebettet wird, wobei unter nahezu eine 85 bis 99 %ige Einbettung des Volumens der eingearbeiteten Komponenten zu verstehen ist und der Anteil der Oberfläche des eingebetteten Materials (5) an der Gesamtoberfläche (8) aber nicht mehr als 35 % beträgt, und im Anschluss daran
b) die Oberfläche des anderen Materials (5) durch Beschuss mit energetischen Schwerionen (11) freigelegt und aktiviert wird und wiederum im Anschluss daran
c) die gesamte Oberfläche (8) mit dem anderen Material (5) beschichtet wird, bis sich mindestens eine geschlossene Schicht des anderen Materials (5) ausbildet,
wobei in Verfahrensschritt a) das thermoplastische Polymer (4) als Substratmaterial eine stark vorstrukturierte Oberfläche aufweist, bei der
- die mittlere Rauheit Rₐ, die den mittleren Abstand eines Messpunktes auf der Oberfläche zur Mittellinie angibt, einen Wert größer als 0,3 µm aufweist und
- sich das strukturierte Oberflächenprofil durch ein ausgeprägtes Tiefenrelief auszeichnet, welches als aus signifikanten Strukturelementen (1, 2, 3) mit schroffen, steilen Wänden zusammengesetzt erscheint, wobei das Verhältnis zwischen der Höhe der einzelnen Strukturelemente (1, 2, 3) und ihrer radialen, das heißt, x- oder y-Ausdehnung mindestens 3 beträgt, und
- die stark vorstrukturierte Oberfläche mit dem aufzubringenden Material (5) beschichtet wird, wobei die Oberfläche durch wenige Monolagen des aufzubringenden Materials (5) partiell bedeckt ist und sich die aufgebrachte Schicht der Oberflächenmorphologie angepasst hat und damit einen nanoskaligen Schichtdickenbereich umfasst, und
- die Beschichtung in der Form ausgeführt ist, dass die Oberfläche (8) des Festkörpers noch nicht vollständig mit dem aufzubringenden Material (5) überzogen ist, das heißt, dass sich noch keine flächendeckende Schicht bezogen auf die insgesamt zur Verfügung stehende freie Oberfläche (7) des thermoplastischen Polymers (4) ausgebildet hat,
der Oberflächen- und der oberflächennahe Festkörperbereich des thermoplastischen Polymers (4) mit der aufgebrachten Schicht des anderen Materials (5) in einem vorgegebenen Zeitintervall, das heißt impulsartig mit einer Impulsdauer im Bereich von 1 ms bis 100 s, durch Wärmezufuhr (T) beeinflusst wird, wobei die Temperatur der Wärmequelle bis zu 500 K oberhalb der Schmelztemperatur des Polymermaterials (4) liegt und
• die Wärmemenge dergestalt dimensioniert wird oder
• auf diese Schicht ein Druck (p), also eine Kraft pro Fläche, der im Bereich zwischen 10 % und 150 % der Zugfestigkeit des Polymermaterials liegt, ausgeübt wird, wobei der Betrag der einzubringenden Wärmemenge (T) und der Druck (p) dergestalt dimensioniert werden,
dass vornehmlich in den Strukturelementen (1, 2, 3) der Oberflächenstrukturierung des Substratmaterials (4), die sich auf der Festkörperoberfläche (8) befinden und den oberflächennahen Bereich darstellen, die Formänderungsfähigkeit des thermoplastischen Polymers (4) zunimmt, bis es beginnt zu fließen und die Schichtstrukturen des aufgebrachten Materials (5) in das Polymermaterial (4) vollständig oder nahezu vollständig einsinken.

3. Verfahren nach Anspruch 2, wobei die starke Vorstrukturierung der Oberfläche, insbesondere bei thermoplastischen Fluorpolymermaterialien (4), durch Bearbeitung mit energetischen Schwerionen (11) erzielt wurde.

4. Verfahren nach Anspruch 2, wobei die starke Vorstrukturierung der Oberfläche durch Methoden der lonenspurtechnologie erzielt wurde.

5. Verfahren nach einem der Ansprüche 1 bis 4, wobei die Anfangsbeschichtung der thermoplastischen Substratoberfläche durch vakuumtechnische Methoden oder durch chemische und elektrochemische Methoden erfolgt.

6. Verfahren nach einem der Ansprüche 1 bis 5, wobei das aufgebrachte Material (5) ein leitfähiges Material ist.

7. Verfahren nach Anspruch 6, wobei in Verfahrensschritt a) das mit einem aufgebrachten leitfähigen Material (5) beschichtete Substrat (4) einer Mikrowellenstrahlung ausgesetzt wird, wobei bei der Bestrahlung mit einem 2,45 GHz-Magnetron die Bestrahlungsleistung im Bereich zwischen 1 Ws/cm² bis 10000 Ws/cm² bei einer Expositionszeit zwischen 0,1 s bis 150 s liegt und zur Optimierung des Wärmeeintrages die Mikrowellenbestrahlungsleistung auch mittels Impulsfolgen zugeführt werden kann, wobei die Impulsbreiten dabei im Bereich von 0,01 s bis zu mehreren Sekunden liegen und die Mikrowellenenergie in der Form ausgelegt ist, dass die dadurch von dem leitfähigen Material absorbierte Wärmeleistung genau so groß wird, dass nur die Zonen des Polymermaterials (4), die unmittelbar mit dem aufgebrachten Material (5) in Kontakt stehen, eine Wärmeabgabe in der Form erfahren, dass sie beginnen, so zu fließen, so dass die Schichtstrukturen des aufgebrachten Materials (5) in das Polymermaterial (4) vollständig oder nahezu vollständig einsinken und eventuell vorhandene Freiräume (6) auffüllen.

8. Verfahren nach Anspruch 6, wobei in Verfahrensschritt a) das mit einem aufgebrachten leitfähigen Material (5) beschichtete Substrat (4) einer Mikrowellenstrahlung ausgesetzt wird, wobei bei der Bestrahlung mit einem 2,45 GHz-Magnetron die Bestrahlungsleistung im Bereich zwischen 1 Ws/cm² bis 10000 Ws/cm² bei einer Expositionszeit zwischen 0,1 s bis 150 s liegt und zur Optimierung des Wärmeeintrages die Mikrowellenbestrahlungsleistung auch mittels Impulsfolgen zugeführt werden kann, wobei die Impulsbreiten dabei im Bereich von 0,01 s bis zu mehreren Sekunden liegen und auf die Oberfläche ein Druck (p), also eine Kraft pro Fläche, der im Bereich zwischen 10 % und 150 % der Zugfestigkeit des Polymermaterials (4) liegt, ausgeübt wird, wobei die Mikrowellenenergie und der Druck in der Form ausgelegt sind, dass die dadurch von dem leitfähigen Material absorbierte Wärmeleistung und der Druck (p) genau so groß werden, dass nur die Zonen des Polymermaterials (4), die unmittelbar mit dem aufgebrachten Material (5) in Kontakt stehen, eine Wärmeabgabe in der Form erfahren, dass sie beginnen, so zu fließen, so dass die Schichtstrukturen des aufgebrachten Materials (5) in das Polymermaterial (4) vollständig oder nahezu vollständig einsinken und eventuell vorhandene Freiräume (6) auffüllen.

9. Verfahren nach einem der Ansprüche 1 bis 8, wobei in Verfahrensschritt b) der Energiebereich für die zur Freilegung des Oberflächenbereiches der in das Polymermaterial (4) eingesunkenen Schichtstrukturen des aufgebrachten Materials (5) und zur Aktivierung des freigelegten Oberflächenbereiches verwendeten energetischen Schwerionen (11) zwischen 1,5 keV und 10 keV liegt.

10. Verfahren nach einem der Ansprüche 1 bis 9, wobei die energetischen Schwerionen (11) aus den Elementen Stickstoff, Sauerstoff, Fluor, Chlor und deren Verbindungen, sowie den Edelgasen Neon, Argon , Krypton, Xenon erzeugt werden können.

11. Verfahren nach einem der Ansprüche 1 bis 10, wobei die Anschlussbeschichtung der thermoplastischen Substratoberfläche durch vakuumtechnische Methoden und/oder durch chemische und/oder elektrochemische Methoden erfolgt.

12. Verfahren nach Anspruch 1, wobei das Substratmaterial (4) eine unbehandelte oder schwach vorstrukturierte Oberfläche aufweist, wobei unter schwach vorstrukturiert verstanden wird, dass die vorhandene Oberflächenstruktur so verstärkt wird, dass die mittlere Rauheit Rₐ, die den mittleren Abstand eines Messpunktes auf der Oberfläche zur Mittellinie angibt, verdoppelt oder verdreifacht wird und das Verhältnis zwischen der Höhe der höchsten und den niedrigsten Profilanteilen maximal 2 beträgt und die Übergänge zwischen höher und niedriger gelegenen Bereichen eher als hügelig oder sanft zu bezeichnen sind, wobei die unbehandelte oder schwach vorstrukturierte Oberfläche mit dem aufzubringenden Material (5) beschichtet wird, und wobei die Struktur des aufgebrachten Materials (5) einer Clusterstruktur (10) entspricht, das heißt einer porösen, perkolierenden oder fraktalen Strukturform des Materials mit einer nanoskaligen Schichtdickenausdehnung, die die Oberfläche des thermoplastischen Kunststoffs, das heißt des thermoplastischen Polymers (4), partiell bedeckt.

13. Verfahren nach Anspruch 12, wobei die schwache Vorstrukturierung der Oberfläche durch Plasmaätzen oder durch plasmaunterstütztes Ätzen erzielt wurde.

14. Verfahren nach Anspruch 12, wobei die schwache Vorstrukturierung der Oberfläche durch Bearbeitung mit energetischen Schwerionen (11) erzielt wurde.

## Claims

1. Process for producing a firmly adhering composite of a substrate material, consisting of a thermoplastic polymer (4) having an untreated surface or a surface which has been treated in order to achieve prestructuring, with another material (5), wherein
a) a first applied layer of the other material (5) having a nanosize layer thickness, i.e. having a layer thickness below 100 nm, is embedded completely or virtually completely into the thermoplastic polymer (4) by thermal treatment, where "virtually" means embedding of from 85 to 99% of the volume of the worked-in components but the proportion of the surface area of the embedded material (5) based on the total surface (8) is not more than 35%, and subsequently
b) the surface of the other material (5) is exposed and activated by bombardment with high-energy heavy ions (11) and in turn subsequently
c) the total surface (8) is coated with the other material (5) until at least a closed layer of the other material (5) is formed,
where, in process step a), the surface region of the thermoplastic polymer (4) with the layer of the other material (5) applied in the form of a nanosize cluster structure (10), i.e. a porous, percolating or fractal structure of the material having a nanosize layer thickness extension, is influenced in a prescribed time interval, i.e. in an impulse-like manner with an impulse duration in the range from 1 ms to 100 s, by supply of heat (T), where the temperature of the heat source is up to 500 K above the melting point of the polymer material (4) and
• the quantity of heat is dimensioned in such a way that or
• a pressure (p), i.e. a force per unit area, which is in the range from 10% to 150% of the tensile strength of the polymer material is exerted on this layer, with the absolute value of the quantity of heat (T) to be introduced and the pressure (p) being dimensioned in such a way that
the deformability of the thermoplastic polymer (4) increases, primarily in the regions of the substrate material, namely of the polymer (4), which are in direct contact with the applied clusters (10), until it begins to flow and the layer structures of the applied material (5) sink completely or virtually completely into the polymer material (4).

2. Process for producing a firmly adhering composite of a substrate material, consisting of a thermoplastic polymer (4) having an untreated surface or a surface which has been treated in order to achieve prestructuring, with another material (5), wherein
a) a first applied layer of the other material (5) having a nanosize layer thickness, i.e. having a layer thickness below 100 nm, is embedded completely or virtually completely into the thermoplastic polymer (4) by thermal treatment, where "virtually" means embedding of from 85 to 99% of the volume of the worked-in components but the proportion of the surface area of the embedded material (5) based on the total surface (8) is not more than 35%, and subsequently
b) the surface of the other material (5) is exposed and activated by bombardment with high-energy heavy ions (11) and once again subsequently
c) the total surface (8) is coated with the other material (5) until a closed layer of the other material (5) is formed,
where, in process step a), the thermoplastic polymer (4) as substrate material has a highly prestructured surface in which
- the average roughness Rₐ, which indicates the average distance of a measured point on the surface from the middle line, has a value greater than 0.3 µm and
- the structured surface profile displays a pronounced depth relief which appears as being composed of significant structural elements (1, 2, 3) having rugged, steep walls, where the ratio between the height of the individual structural elements (1, 2, 3) and their radial, i.e. x or y, extension is at least 3, and
- the highly prestructured surface is coated with the material (5) to be applied, where the surface is partially covered by a few monolayers of the material (5) to be applied and the applied layer has fitted to the surface morphology and thus comprises a nanosize layer thickness range, and
- coating is carried out in such a way that the surface (8) of the solid is not completely coated with the material (5) to be applied, i.e. a surface-covering layer, based on the total available free surface (7) of the thermoplastic polymer (4), has not yet formed,
the surface and near-surface solid region of the thermoplastic polymer (4) with the applied layer of the other material (5) is influenced in a prescribed time interval, i.e. in an impulse-like manner with an impulse duration in the range from 1 ms to 100 s, by supply of heat (T), where the temperature of the heat source is up to 500 K above the melting point of the polymer material (4) and
• the quantity of heat is dimensioned in such a way that or
• a pressure (p), i.e. a force per unit area, which is in the range from 10% to 150% of the tensile strength of the polymer material is exerted on this layer, with the absolute value of the quantity of heat (T) to be introduced and the pressure (p) being dimensioned in such a way that
the deformability of the thermoplastic polymer (4) increases, primarily in the structural elements (1, 2, 3) of the surface structuring of the substrate material (4) which are located on the solid surface (8) and represent the near-surface region, until it begins to flow and the layer structures of the applied material (5) sink completely or virtually completely into the polymer material (4).

3. Process according to Claim 2, wherein the high prestructuring of the surface has, especially in the case of thermoplastic fluoropolymer materials (4), been achieved by treatment with high-energy heavy ions (11).

4. Process according to Claim 2, wherein the high prestructuring of the surface has been achieved by methods of ion track technology.

5. Process according to any of Claims 1 to 4, wherein the initial coating of the thermoplastic substrate surface is effected by vacuum methods or by chemical and electrochemical methods.

6. Process according to any of Claims 1 to 5, wherein the applied material (5) is a conductive material.

7. Process according to Claim 6, wherein, in process step a), the substrate (4) coated with an applied conductive material (5) is exposed to microwave radiation, where in the case of irradiation with a 2.45 GHz magnetron the irradiation power is in the range from 1 Ws/cm² to 10000 Ws/cm² at an exposure time in the range from 0.1 s to 150 s and the microwave irradiation power can also be supplied by means of impulse sequences in order to optimize the energy input, where the impulse widths are in the range from 0.01 s to a number of seconds and the microwave energy is in such a form that the heat power thereby absorbed by the conductive material becomes precisely so great that only the zones of the polymer material (4) which are in direct contact with the applied material (5) experience heat input such that they begin to flow, so that the layer structures of the applied material (5) sink completely or virtually completely into the polymer material (4) and fill any free spaces (6) present.

8. Process according to Claim 6, wherein, in process step a), the substrate (4) coated with an applied conductive material (5) is exposed to microwave radiation, where in the case of irradiation with a 2.45 GHz magnetron the irradiation power is in the range from 1 Ws/cm² to 10000 Ws/cm² at an exposure time in the range from 0.1 s to 150 s and the microwave irradiation power can also be supplied by means of impulse sequences in order to optimize the heat input, where the impulse widths are in the range from 0.01 s to a number of seconds and a pressure (p), i.e. a force per unit area, which is in the range from 10% to 150% of the tensile strength of the polymer material (4) is exerted on the surface, where the microwave energy and the pressure are in such a form that the heat power thereby absorbed by the conductive material and the pressure (p) become precisely so great that only the zones of the polymer material (4) which are in direct contact with the applied material (5) experience heat input such that they begin to flow, so that the layer structures of the applied material (5) sink completely or virtually completely into the polymer material (4) and fill any free spaces (6) present.

9. Process according to any of Claims 1 to 8, wherein, in process step b), the energy range for the high-energy heavy ions (11) used for exposing the surface region of the layer structures of the applied material (5) which have sunk into the polymer material (4) and for activating the exposed surface region is from 1.5 keV to 10 keV.

10. Process according to any of Claims 1 to 9, wherein the high-energy heavy ions (11) can be produced from the elements nitrogen, oxygen, fluorine, chlorine and compounds thereof and also the noble gases neon, argon, krypton, xenon.

11. Process according to any of Claims 1 to 10, wherein the subsequent coating of the thermoplastic substrate surface is effected by vacuum methods and/or by chemical and/or electrochemical methods.

12. Process according to Claim 1, wherein the substrate material (4) has an untreated or weakly prestructured surface, where "weakly prestructured" means that the surface structure present is reinforced so that the average roughness Rₐ, which indicates the average distance of a measurement point on the surface from the middle line, is doubled or tripled and the ratio of the height of the highest and the lowest part of the profile is not more than two and the transitions between two relatively high and relatively low regions can be described as hilly or gentle, where the untreated or weakly prestructured surface is coated with the material (5) to be applied and where the structure of the applied material (5) corresponds to a cluster structure (10), i.e. a porous, percolating or fractal structure of the material with a nanosize layer thickness extension, which partially covers the surface of the thermoplastic material, i.e. the thermoplastic polymer (4).

13. Process according to Claim 12, wherein the weak prestructuring of the surface has been achieved by plasma etching or by plasma enhanced etching.

14. Process according to Claim 12, wherein the weak prestructuring of the surface has been achieved by treatment with high-energy heavy ions (11).

## Revendications

1. Procédé de réalisation d'une liaison par adhérence d'un matériau de substrat, qui comprend un polymère thermoplastique (4) pourvu d'une surface non traitée ou d'une surface traitée pour obtenir une pré-structuration, à un autre matériau (5), procédé dans lequel
a) une première couche appliquée de l'autre matériau (5) d'une épaisseur de couche nanométrique, c'est-à-dire d'une épaisseur de couche inférieure à 100 nm, est complètement ou presque complètement intégrée dans le polymère thermoplastique (4) par traitement thermique, 'presque' devant être compris comme une intégration de 85 à 99 % du volume des composants incorporés et la proportion de la surface du matériau intégré (5) rapportée à la surface totale (8) n'étant pas supérieure à 35 %, puis
b) la surface de l'autre matériau (5) est exposée et activée par bombardement avec des ions lourds énergétiques (11) puis de nouveau
c) toute la surface (8) est recouverte de l'autre matériau (5) jusqu'à former au moins une couche fermée de l'autre matériau (5),
à l'étape a) du procédé, la zone de surface du polymère thermoplastique (4) pourvue de la couche de l'autre matériau (5) qui a été appliquée sous la forme d'une structure en grappe nanométrique (10), c'est-à-dire d'une forme structurelle poreuse, percolante ou fractale du matériau ayant une extension d'épaisseur de couche nanométrique, étant influencée par apport de chaleur (T) dans un intervalle de temps spécifié, c'est-à-dire de type impulsionnel d'une durée d'impulsion dans la gamme allant de 1 ms à 100s, la température de la source de chaleur atteignant 500 K au-dessus de la température de fusion du matériau polymère (4) et
• la quantité de chaleur étant dimensionnée de manière à ce que, ou
• une pression (p), donc une force par unité de surface dans la gamme comprise entre 10 % et 150 % de la résistance à la traction du matériau polymère, étant exercée sur cette couche, la quantité de chaleur (T) à apporter et la pression (p) étant dimensionnées de manière à ce que
la déformabilité du polymère thermoplastique (4) augmente principalement dans les zones du matériau de substrat du polymère (4), qui sont en contact direct avec les grappes appliquées (10), jusqu'à ce que ledit polymère commence à s'écouler et les structures en couches du matériau appliqué (5) s'enfoncent complètement ou presque complètement dans le matériau polymère (4).

2. Procédé de réalisation d'une liaison par adhérence d'un matériau de substrat, qui comprend un polymère thermoplastique (4) pourvu d'une surface non traitée ou d'une surface traitée pour obtenir une pré-structuration, à un autre matériau (5), procédé dans lequel
a) une première couche appliquée de l'autre matériau (5) d'une épaisseur de couche nanométrique, c'est-à-dire d'une épaisseur de couche inférieure à 100 nm, est complètement ou presque complètement intégrée dans le polymère thermoplastique (4) par traitement thermique, 'presque' devant être compris comme une intégration de 85 à 99 % du volume des composants incorporés et la proportion de la surface du matériau intégré (5) rapportée à la surface totale (8) n'étant pas supérieure à 35 %, puis
b) la surface de l'autre matériau (5) est exposée et activée par bombardement avec des ions lourds énergétiques (11) puis de nouveau
c) toute la surface (8) est recouverte de l'autre matériau (5) jusqu'à former au moins une couche fermée de l'autre matériau (5),
à l'étape de procédé a) le polymère thermoplastique (4) comportant comme matériau de substrat une surface hautement pré-structurée dans laquelle
- la rugosité moyenne Rₐ, qui indique la distance moyenne d'un point de mesure sur la surface à la ligne médiane, a une valeur supérieure à 0,3 µm et
- le profil de surface structurée est **caractérisé par** un relief de profondeur prononcé, qui semble composé d'éléments structurels significatifs (1, 2, 3) à parois rugueuses et abruptes, le rapport entre la hauteur des éléments structurels individuels (1, 2, 3) et leur extension radiale, c'est-à-dire x ou y, étant d'au moins 3, et
- la surface fortement pré-structurée étant revêtue du matériau (5) à appliquer, la surface étant partiellement recouverte de quelques monocouches du matériau (5) à appliquer et la couche appliquée s'étant adaptée à la morphologie de surface et comprenant ainsi une gamme d'épaisseurs de couche nanométrique, et
- le revêtement est effectué de manière à ce que la surface (8) du corps solide ne soit pas encore complètement recouverte du matériau (5) à appliquer, c'est-à-dire qu'il ne s'est pas encore formé de couche de revêtement de surface par rapport à la surface libre (7) totale disponible du polymère thermoplastique (4),
la zone solide en surface et proche de la surface du polymère thermoplastique (4) pourvu de la couche appliquée de l'autre matériau (5) étant influencée par apport de chaleur (T) dans un intervalle de temps spécifié, c'est-à-dire de type impulsionnel d'une durée d'impulsion dans la gamme allant de 1 ms et 100 s, la température de la source de chaleur atteignant 500 K au-dessus de la température de fusion du matériau polymère (4) et
• la quantité de chaleur étant dimensionnée de manière à ce que, ou
• une pression (p), donc une force par unité de surface dans la gamme comprise entre 10 % et 150 % de la résistance à la traction du matériau polymère, étant exercée sur cette couche, la quantité de chaleur (T) à apporter et la pression (p) étant dimensionnées de manière à ce que
la déformabilité du polymère thermoplastique (4) augmente principalement dans les éléments structurels (1, 2, 3) de la structure de surface du matériau de substrat (4), qui se trouvent sur la surface solide (8) et représentent la zone proche de la surface, jusqu'à ce que ledit polymère commence à s'écouler et les structures en couches du matériau appliqué (5) s'enfoncent complètement ou presque complètement dans le matériau polymère (4) .

3. Procédé selon la revendication 2, la forte pré-structuration de la surface, en particulier dans le cas de matériaux fluoropolymères thermoplastiques (4), ayant été obtenue par traitement avec des ions lourds énergétiques (11).

4. Procédé selon la revendication 2, la forte pré-structuration de la surface ayant été obtenue par des méthodes de technologie de traces d'ions.

5. Procédé selon l'une des revendications 1 à 4, le revêtement initial de la surface de substrat thermoplastique étant effectué par des méthodes sous vide ou par des méthodes chimiques et électrochimiques.

6. Procédé selon l'une des revendications 1 à 5, le matériau appliqué (5) étant un matériau conducteur.

7. Procédé selon la revendication 6, à l'étape de procédé a) le substrat (4) revêtu d'un matériau conducteur (5) qui a été appliqué étant exposé à un rayonnement micro-onde, dans le cas d'une irradiation avec un magnétron de 2,45 GHz la puissance d'irradiation étant comprise entre 1 Ws/cm2 et 10000 Ws/cm2 avec un temps d'exposition compris entre 0,1 s et 150 s et, pour optimiser l'apport de chaleur, la puissance de rayonnement micro-onde pouvant également être apportée au moyen de séquences d'impulsions, les largeurs d'impulsions étant dans la gamme de 0,01 s à plusieurs secondes et l'énergie des micro-ondes étant dimensionnée de manière à ce que la puissance thermique ainsi absorbée par le matériau conducteur soit juste assez grande pour que seules les zones du matériau polymère (4) qui sont en contact direct avec le matériau (5) appliqué subissent une dissipation thermique telle qu'elles commencent à s'écouler de sorte que les structures en couches du matériau (5) appliqué s'enfoncent complètement ou presque complètement dans le matériau polymère (4) et remplissent des espaces libres (6) éventuellement présents.

8. Procédé selon la revendication 6, à l'étape de procédé a), le substrat (4) revêtu d'un matériau conducteur (5) qui a été appliqué étant exposé à un rayonnement micro-onde, dans le cas de l'irradiation avec un magnétron de 2,45 GHz la puissance d'irradiation étant comprise entre 1 Ws/cm2 et 10000 Ws/cm2 avec un temps d'exposition compris entre 0,1 s et 150 s et, pour optimiser l'apport de chaleur, la puissance de rayonnement micro-onde pouvant également être apportée au moyen de séquences d'impulsions, les largeurs d'impulsion étant comprises entre 0,01 s et plusieurs secondes et une pression (p), c'est-à-dire une force par unité de surface comprise entre 10 % et 150 % de la résistance à la traction du matériau polymère (4), étant exercée sur la surface, l'énergie micro-onde et la pression étant dimensionnées de manière à ce que la puissance thermique ainsi absorbée par le matériau conducteur et la pression (p) soient juste assez grandes pour que seules les zones du matériau polymère (4) qui sont en contact direct avec le matériau (5) appliqué subissent une dissipation thermique telle qu'elles commencent à s'écouler de sorte que les structures en couches du matériau (5) appliqué s'enfoncent complètement ou presque complètement dans le matériau polymère (4) et remplissent des espaces libres (6) éventuellement présents.

9. Procédé selon l'une des revendications 1 à 8, à l'étape de procédé b) la gamme d'énergie des ions lourds énergétiques (11), qui sont utilisés pour exposer la zone de surface des structures en couches du matériau (5) appliqué qui sont enfoncées dans le matériau polymère (4) et pour activer la zone de surface exposée, étant comprise entre 1,5 keV et 10 keV.

10. Procédé selon l'une des revendications 1 à 9, les ions lourds énergétiques (11) pouvant être générés à partir des éléments azote, oxygène, fluor, chlore et leurs composés, ainsi que des gaz nobles néon, argon, krypton, xénon.

11. Procédé selon l'une des revendications 1 à 10, le revêtement de liaison de la surface de substrat thermoplastique étant effectué par des méthodes de technologie sous vide et/ou par des méthodes chimiques et/ou électrochimiques.

12. Procédé selon la revendication 1, le matériau de substrat (4) comportant une surface non traitée ou légèrement pré-structurée, 'légèrement pré-structurée' signifiant que la structure de surface existante est renforcée de telle sorte que la rugosité moyenne Rₐ, qui indique la distance moyenne entre un point de mesure sur la surface et la ligne médiane, soit doublée ou triplée et que le rapport entre la hauteur des parties de profil les plus hautes et les plus basses sont au maximum de 2 et les transitions entre les zones supérieures et inférieures peuvent être décrites comme vallonnées ou douces, la surface non traitée ou légèrement pré-structurée étant revêtue du matériau (5) à appliquer, et la structure du matériau (5) appliqué correspondant à une structure en grappe (10), c'est-à-dire à une forme structurelle poreuse, percolante ou fractale du matériau avec une extension d'épaisseur de couche nanométrique qui recouvre partiellement la surface du matériau thermoplastique, c'est-à-dire du polymère thermoplastique (4).

13. Procédé selon la revendication 12, la faible pré-structuration de la surface ayant été obtenue par gravure plasma ou par gravure assistée par plasma.

14. Procédé selon la revendication 12, la faible pré-structuration de la surface ayant été obtenue par traitement avec des ions lourds énergétiques (11).
